# EUROPEAN PATENT SPECIFICATION

(11) **EP 2 717 666 B1**
(45) Date of publication and mention of the grant of the patent: **20.01.2021**
(21) Application number: 12793184.8
(22) Date of filing: 24.05.2012
(51) Int. Cl.: H05K 13/08, H05K 3/34, H05K 13/00

(54) **BOARD OPERATION ASSISTING DEVICE, AND BOARD OPERATION ASSISTING METHOD**
VORRICHTUNG ZUR UNTERSTÜTZUNG DES BETRIEBS EINER LEITERPLATTE UND VERFAHREN ZUR UNTERSTÜTZUNG DES BETRIEBS EINER LEITERPLATTE
DISPOSITIF D'AIDE À DES OPÉRATIONS SUR DES CARTES, PROCÉDÉ D'AIDE À DES OPÉRATIONS SUR DES CARTES

(30) Priority: 31.05.2011 JP 2011121637; 31.05.2011 JP 2011121939; 14.11.2011 JP 2011248811
(43) Date of publication of application: 09.04.2014
(73) Proprietor: FUJI Corporation, Chiryu Aichi (JP)
(72) Inventor: SUZUKI, Toshiya, Chiryu, Aichi (JP); HANEDA, Hiroyuki, Chiryu, Aichi (JP); NAKAYAMA, Daisuke, Chiryu, Aichi (JP)
(74) Representative: Grünecker Patent- und Rechtsanwälte PartG mbB
(86) International application number: PCT/JP2012/063278
(87) International publication number: WO 2012/165276

(56) References cited:
- JP-A- 7 007 262
- JP-A- 9 289 396
- JP-A- 2006 073 961
- JP-A- 2008 171 330
- US-A- 5 607 097
- US-A1- 2003 125 895

## Description

### TECHNICAL FIELD

The present invention relates to a device and a method of assisting a circuit-substrate-related work performed by a circuit-substrate-related-work performing machine on a circuit substrate that constitutes an electric circuit.

### BACKGROUND ART

There have been conventionally made various studies about assistance for production of electric circuits by an electric-circuit production line. There is known a system described in JP-A-6-112295 as a system for performing assistance regarding the quality of produced electric circuits. The system includes: a circuit-substrate-related-work performing machine configured to perform a work on circuit substrates such as a printing work for printing solder cream, a mounting work for mounting electric components, or the like; and an inspecting machine configured to inspect a result of the work performed by the circuit-substrate-related-work performing machine. (Hereinafter, the work performed on the circuit substrates will be referred to as "circuit-substrate-related work" where appropriate.) In the system, quality deterioration that does not reach a level to be identified as a failure is grasped and coped with on the basis of inspection data of the inspecting machine, thereby making it possible to maintain high reliability in the quality of the electric circuits to be produced.

US 5,607,097 A discloses a circuit-substrate-related-work assisting device consisting of a soldering printing part, a mounting part, a soldering part which are provided with a product quality information collector and equipment trouble information collector. A memory stores equipment trouble information, a product quality information, a maintenance information, a maintenance result information and quality information. A related analysis part combines contents of each information and analyses degree of frequency appearance of an item. A prediction and presumed rule predicts or estimates the cause or result of a trouble, quality and maintenance. A counter measure analysis part searches the prediction and presumed rule and displays a maintenance indication on a display.

US 2003/125895 A1 discloses an apparatus and method for inspecting working operations on a circuit substrate, and a system and method for fabricating an electric circuit.

### SUMMARY OF INVENTION

### TECHNICAL PROBLEM

In an instance where the circuit-substrate-related work is assisted in terms of the quality deterioration, it is effective to determine an improvement action for the quality deterioration and to transmit information as to the action to the circuit-substrate-related-work performing machine or to notify an operator of the circuit-substrate-related-work performing machine of the action. Such transmission or notification enables the circuit-substrate-related-work performing machine to automatically implement an appropriate action or enables the operator per se to implement an appropriate action. However, there is plenty of room for improvement in such assistance, and it is possible to enhance utility of a device to perform the assistance and a method of performing the assistance by making some improvements. The present invention has been made in the light of such situations, and it is therefore an object of the invention to provide a device and a method, with high utility, for assisting a circuit-substrate-related work in terms of the quality deterioration.

### SOLUTION TO PROBLEM

To achieve the object indicated above, a circuit-substrate-related-work assisting device and a circuit-substrate-related-work assisting method according to the invention is defined in independent claims 1 and 5, respectively. Preferred embodiments are set out in the dependent claims.

### ADVANTAGEOUS EFFECTS OF INVENTION

According to the circuit-substrate-related-work assisting device and the circuit-substrate-related-work assisting method of the present invention, it is possible to appropriately confirm improvement effects of the quality by the implemented improvement action. Therefore the assisting device and the assisting method have high utility.

### FORMS OF INVENTION

There will be explained various forms relating to the invention.

In the following forms, form (3) corresponds to claim 1, the forms (4)-(6) respectively correspond to claims 2-4, and the form (11) corresponds to claim 5.
(1) A circuit-substrate-related-work assisting device configured to assist a circuit-substrate-related work performed by a circuit-substrate-related-work performing machine on a circuit substrate that constitutes an electric circuit, comprising:
   a quality judging portion configured to make a judgment as to a change in work quality of the circuit-substrate-related-work performing machine;
   an improvement-action determining portion configured to determine an improvement action for improving the work quality where the quality judging portion judges that a degree of deterioration of the work quality exceeds a prescribed degree;
   an action notifying portion configured to notify at least one of the circuit-substrate-related-work performing machine and an operator of the circuit-substrate-related-work performing machine of the improvement action determined by the improvement-action determining portion; and
   an action-completion-information receiving portion configured to receive, from at least one of the circuit-substrate-related-work performing machine and the operator, action-completion information that is information as to completion of the improvement action notified by the action notifying portion,
   wherein the quality judging portion is configured to judge whether the circuit substrate is the circuit substrate on which the circuit substrate related work was performed after implementation of the improvement action and to make a judgment as to a change in the work quality before and after the completion of the improvement action, conditionally on reception of the action-completion information by the action-completion-information receiving portion.

   This form is a form of the claimable invention belonging to a category of a device, namely, a form of a circuit-substrate-related-work assisting device (hereinafter simply referred to as "assisting device" where appropriate) relating to the claimable invention. The "circuit-substrate-related work" in this form means a work performed on a circuit substrate (hereinafter simply referred to as "substrate" where appropriate) in an ordinary electric circuit production. The circuit-substrate-related work includes various sorts of works such as: a solder printing work in which solder cream is printed on a surface of the substrate; a component mounting work in which electric components (hereinafter simply referred to as "components" where appropriate) are mounted on the solder-printed substrate; and a component fixing work in which the components are fixed to the substrate by heating and cooling the component-mounted substrate so as to melt and solidify the solder. The "circuit-substrate-related-work performing machine" includes various sorts of machines such as a solder printer, a component mounter, a reflow furnace, and so on, each configured to perform a corresponding one of the circuit-substrate-related works.
   The "judgment as to a change in work quality of the circuit-substrate-related-work performing machine" made by the quality judging portion of the assisting device in this form briefly means grasping to what extent the work quality in all or a selected part of work-subjected portions on which the circuit-substrate-related work was performed is improved or deteriorated. That is, the level of the work quality is not a narrow concept that a work failure actually occurred, but means lowness of a possibility of occurrence of the work failure. Accordingly, the deterioration of the work quality may be considered as a sign of the occurrence of the work failure, and grasping of the deterioration of the work quality is effective to obviate the occurrence of the work failure. In this respect, the level of the work quality may be indicated by various statistical indices such as stability (which will be explained) used in the field of quality control, and the judgment as to the change in the work quality may be made on the basis of a change degree of a value of the indices. The "work-subjected portions" used herein vary depending on the kind of the circuit-substrate-related work. In the solder printing work, solder lands (which may be also referred to as "solder pads") correspond to the work-subjected portions, for instance. In the component mounting work, the mounted electric components correspond to the work-subjected portions, for instance. In the component fixing work, components fixed to the substrate and solder solidified for fixing the components correspond to the work-subjected portions, for instance.
   The judgment by the quality judging portion may be made for only specific work-subjected portions. As will be later explained, the deterioration of the work quality is likely to occur due to a work-condition change. To be more specific, the work-condition change is recognized, and the judgment may be made for only work-subjected portions that will be susceptible to the recognized work-condition change in terms of the work quality. Alternatively, the judgment may be made for all of or a part of the work-subjected portions, irrespective of recognition of the work-condition change.
   In the assisting device according to this form, the improvement action for improving the deteriorated work quality is determined by the improvement-action determining portion, and the determined improvement action is notified by the action notifying portion. By implementing the action, the occurrence of the failure is eliminated, obviated, and suppressed. In this sense, it is possible to carry out advanced assistance with regard to the quality of the electric circuit according to this form.
   As will be later explained, a mode of the deterioration of the work quality, more specifically, the work-subjected portions that suffer from the quality deterioration, details of the quality deterioration, and so on vary depending on details of the work-condition change. Accordingly, the determination of the improvement-action determining portion may be made on the basis of the mode of the deterioration of the work quality. Concretely, an appropriate improvement action may be determined by estimating the details of the work-condition change from the mode of the deterioration of the work quality. Further, in an instance where the work-condition change is recognized in advance, an appropriate improvement action may be determined in accordance with the work-condition change when it is judged that the quality deterioration due to the work-condition change is occurring. To be more specific, the improvement action may be set in advance in accordance with the details of the work-condition change, and the determination may be made according to the setting.
   The notification of the improvement action to the circuit-substrate-related-work performing machine by the action notifying portion is convenient in a case in which the improvement action is automatically implementable in the circuit-substrate-related-work performing machine. In contrast, the notification of the improvement action to the operator is effective in a case in which the improvement action cannot be automatically implemented by the circuit-substrate-related-work performing machine. The notification to the operator includes a case in which the improvement action is notified directly from an operation panel or the like of the assisting device and a case in which the improvement action is notified indirectly via the operation panel or the like of the circuit-substrate-related-work performing machine. Similarly, the reception of the action-completion information by the action-completion-information receiving portion may be carried out such that the circuit-substrate-related-work performing machine automatically detects completion of the improvement action and information sent to the assisting device is received by the action-completion-information receiving portion. Alternatively, the reception may be carried out such that information inputted by the operator may be received by the action-completion-information receiving portion. The latter includes a case in which the action-completion-information receiving portion directly receives information inputted by the operator through the operation panel or the like of the assisting device and a case in which the action-completion-information receiving portion indirectly receives information inputted by the operator through the operation panel or the like of the circuit-substrate-related-work performing machine, via the circuit-substrate-related-work performing machine.
   If it is not possible to note the completion of the improvement action, it is difficult to appropriately grasp improvement effects of the quality by the improvement action. In the assisting device according to this form, the quality judging portion is configured to make the judgment as to the change in the work quality before and after the completion of the improvement action, conditionally on reception of the action-completion information by the action-completion-information receiving portion. According to the assisting device in this form, therefore, it is possible to confirm the improvement effects of the quality by the implemented improvement action. The wording "conditionally on reception of the action-completion information" may be interpreted so as to mean "triggered by reception of the action-completion information".
   The assisting device in this form may be provided outside an electric-circuit production line (hereinafter simply referred to as "production line" where appropriate) in which the circuit-substrate-related-work performing machine is disposed or may constitute a part of the production line, more specifically, a part of the circuit-substrate-related-work performing machine or the inspecting machine configured to inspect a result of the circuit-substrate-related work performed by the circuit-substrate-related-work performing machine. The assisting device is constituted by some functional portions including the quality judging portion, the improvement-action determining portion, the action notifying portion, and the action-completion-information receiving portion. The assisting device may be realized, as a single device, by the entirety of the functional portions or may be realized by at least two devices such that a part of the functional portions are provided in the circuit-substrate-related-work performing machine and the inspecting machine, etc.
(2) The circuit-substrate-related-work assisting device according to the form (1), wherein the improvement-action determining portion is configured to determine another improvement action different from the determined improvement action where there are no singes of improvement in the work quality even though the determined improvement action has been implemented on the circuit-substrate-related-work performing machine.
   In the assisting device according to this form, a plurality of improvement actions are determined and notified stepwise. Therefore, the assisting device in this form ensures further advanced assistance with regard to the quality of the circuit-substrate-related work.
(3) The circuit-substrate-related-work assisting device according to the form (2), wherein the improvement-action determining portion is configured to determine said another improvement action according to a priority order set in advance.
   In this form, a limitation is added to the stepwise determination of the plurality of improvement actions. The priority order may be set considering the details of the work-condition change recognized in advance or estimated from the mode of the quality deterioration, ease with which the improvement action is implemented, a time required for implementing the improvement action, a degree of effects of the improvement action, etc. In this respect, a plurality of groups including a plurality of improvement actions may be set so as to have mutually different priority orders. In this instance, one of the plurality of groups may be selected in accordance with a certain situation or condition, and the improvement action to be implemented may be stepwise determined from among the improvement actions that belong to the selected group, according to the priority order set for the selected group.
(4) The circuit-substrate-related-work assisting device according to any one of the forms (1)-(3), wherein the quality judging portion is configured to make the judgment as to the change in the work quality, based on stability for at least one of the circuit-substrate-related work and a work result of the circuit-substrate-related work.
   The "stability of the circuit-substrate-related work" in this form includes stability of an operation of the circuit-substrate-related-work performing machine and stability of a movement, state, etc., of a target object in the operation. To be more specific, the stability means accuracy of the operation (conversely, a degree of not causing operation errors) and a degree of smallness of variations with regard to a deviation or the like of an operation speed, an operation force, or a position or a state of the operation target object, from a normal speed, a normal force, or a normal position or state. The "stability of the work result" means a degree of smallness of variations of the work result. To be more specific, where the circuit-substrate-related work is the solder printing work, the stability of the work result means stability with regard to a positional deviation of each printed solder land from a normal print position (that is a concept including a deviation with regard to a rotational position, i.e., an orientation) and stability with regard to a deviation (an increase or a decrease) from a normal area or a normal volume, such as a thin spot, an expansion, a protrusion or the like of each printed solder land. Where the circuit-substrate-related work is the component mounting work, the stability of the work result means stability with regard to a positional deviation of each mounted component from a normal mount position. Where the circuit-substrate-related work is the component fixing work, the stability of the work result means stability with regard to a positional deviation of the fixed component from a normal fixation position and stability with regard to a deviation (an increase) of solidified solder from a normal area, such as an expansion. Concrete examples of the stability of the circuit-substrate-related work and the stability of the work result will be explained. The stability of the circuit-substrate-related work and the stability of the work result are suitable parameters for predicting the quality level in the work-subjected portions, namely, for predicting a degree of possibility that the work-subjected portions become failure portions. By making the judgment as to the change in the quality on the basis of the stability, it is possible to appropriately make a judgment as to the deterioration, the improvement, etc., in the work quality. As the stability, there may be employed various statistical indices used in the field of quality control, such as a number of times or a probability of operation errors, an average of deviation amounts from a reference value for the above-indicated various deviations, a relationship between the deviation amounts and a control limit value, a distribution range of the deviations, and a process capability index.
(5) The circuit-substrate-related-work assisting device according to any one of the forms (1)-(4), wherein the circuit-substrate-related-work performing machine is a component mounter configured to perform, as the circuit-substrate-related work, a component mounting work for mounting electric components on the circuit substrate, and the circuit-substrate-related-work assisting device is a device for assisting the component mounting work.
(6) The circuit-substrate-related-work assisting device according to any one of the forms (1)-(4), wherein the circuit-substrate-related-work performing machine is a solder printer configured to perform, as the circuit-substrate-related work, a solder printing work for printing solder cream on the circuit substrate, and the circuit-substrate-related-work assisting device is a device for assisting the solder printing work.
   In each of the above two forms, there are added a limitation relating to the kind of the circuit-substrate-related-work performing machine and the kind of the circuit-substrate-related work.
(7) The circuit-substrate-related-work assisting device according to any one of the forms (1)-(6), further comprising:
   a condition-change recognizing portion configured to recognize a work-condition change that is a change of a work condition in the circuit-substrate-related work, based on machine-related information that includes information as to at least one of a work that the circuit-substrate-related-work performing machine performed in the circuit-substrate-related work and action that was implemented on the circuit-substrate-related-work performing machine; and
   a monitor-target-portion identifying portion configured to specify work-subjected portions that will be susceptible to the recognized work-condition change in terms of the work quality and to identify, as a monitor-target portion, at least one of the specified work-subjected portions,
   wherein the quality judging portion is configured to make a judgment as to a change in the work quality in the monitor-target portion by comparing comparison data for circuit substrates on which the circuit-substrate-related work was performed before occurrence of the recognized work-condition change and comparison data for circuit substrates on which the circuit-substrate-related work was performed after occurrence of the recognized work-condition change, the comparison data including at least one of operation-based data obtained based on operations of the circuit-substrate-related-work performing machine and inspection data by an inspecting machine configured to inspect work results of the circuit-substrate-related work performed by the circuit-substrate-related-work performing machine.

   The assisting device according to this form has a function of limiting the work-subjected portion as a monitor target in the judgment as to the change in the work quality. Therefore, the assisting device according to this form is capable of efficiently monitoring the deterioration in the work quality in the circuit-substrate-related work.
   The "work-condition change" recognized by the condition-change recognizing portion will be explained. the "work condition" refers to a concept for meaning what the following various factors are: a structure of the circuit-substrate-related-work performing machine such as various devices installed thereon and a status of the circuit-substrate-related-work performing machine; a material used in the circuit-substrate-related work such as substrates, component, and solder; a mode of a work procedure and a work operation in the circuit-substrate-related work; an environment in which the circuit-substrate-related-work performing machine operates or to be operated. The "work-condition change" refers to a concept that means the factors change or are changed. Concrete examples of the work-condition change will be explained.
   The "machine-related information" based on which the condition-change recognizing portion recognizes the work-condition change broadly means information for indicating, for instance, what kind of devices and materials were used, what kind of operations were performed, in what status the circuit-substrate-related-work performing machine was placed, etc., when the circuit-substrate-related-work performing machine performed the circuit-substrate-related work on one substrate. The machine-related information includes at least one of: information as to a work that the circuit-substrate-related-work performing machine performed (hereinafter referred to as "work performance information" where appropriate): and information as to an action that was implemented on the circuit-substrate-related-work performing machine (hereinafter referred to as "action information" where appropriate). Concrete examples of the two sorts of information will be explained. Although the machine-related information is mainly sent from the circuit-substrate-related-work performing machine, it may be sent from other devices. For instance, the machine-related information may be obtained by the assisting device per se on the basis of an input by the operator to the operation panel or the like.
   To "recognize a work-condition change" by the condition-change recognizing portion not only means confirmation that the work-condition change occurred, but also means specification of details of the occurred work-condition change. The recognition of the work-condition change also means recognition of an event that induces the work-condition change, namely, a work-condition-change event.
   The "work-subjected portions that will be susceptible to the work-condition change in terms of the work quality" (hereinafter referred to as "susceptible portions" where appropriate) specified by the monitor-target-portion identifying portion may be a part of or all of the work-subjected portions in one substrate. The susceptible portions vary depending on the kind of the circuit-substrate-related work and the details of the work-condition change. The "monitor-target portion" may be all of the susceptible portions or a part of the susceptible portions. An increase in the number of the susceptible portions each recognized as the monitor-target portion enhances the reliability in the quality of the electric circuits to be produced whereas a load of processing to be performed by a target-portion-quality judging portion (that will be explained) becomes large. Determination as to how many susceptible portions are identified as the monitor-target portion and recognition as to which susceptible portions are identified as the monitor-target portion may be made in view of the reliability in the quality and the load of processing while considering the kind of the circuit-substrate-related work, the details of the work-condition change, etc.
   The "comparison data" used in the judgment by the target-portion-quality judging portion includes at least one of the operation-based data and the inspection data. To be more specific, the "operation-based data" includes various sorts of data that is detectable, measureable, and recognizable in the circuit-substrate-related-work performing machine, such as data relating to the operation necessary when the circuit-substrate-related-work performing machine performs the circuit-substrate-related work, data relating to a status of the circuit-substrate-related-work performing machine when the circuit-substrate-related-work performing machine is performing the operation or after the circuit-substrate-related-work performing machine performed the operation, and data relating to the movement and the status of the operation target object. In general, an inspecting machine is disposed on a downstream side of the circuit-substrate-related-work performing machine (meaning not only on an immediately downstream side, but also on a downstream side with other devices interposed therebetween). As the "inspection data", there is employable data obtained by the inspecting machine, more specifically, the inspection data of each of the work-subjected portions obtained when the inspecting machine inspected a work result of each of the work-subjected portions. Concrete examples of the comparison data, namely, concrete examples of the operation-based data and the inspection data, will be later described.
(8) The circuit-substrate-related-work assisting device according to the form (7), wherein the monitor-target-portion identifying portion is configured to identify each of some of the work-subjected portions as the monitor-target portion, according to a rule that is set by considering ease with which an influence of the work-condition change on the work quality appears.
   The number of the susceptible portions indicated above may become considerable large depending on the kind of the circuit-substrate-related work, the details of the work-condition change, and so on. According to this form, even where the number of the susceptible portions is large, it is possible to efficiently monitor the quality deterioration of the electric circuit. The "rule that is set by considering ease with which an influence of the work-condition change on the work quality appears" may be expressed as a rule for selecting portions that will be likely to suffer from the quality deterioration due to the work-condition change, for instance. The rule may be set on the basis of the size of each work-subjected portion, the position of each work-subjected portion on the substrate, etc., depending on the kind of the circuit-substrate-related work, the details of the work-condition change, etc.
(9) The circuit-substrate-related-work assisting device according to the form (7) or (8), wherein the circuit-substrate-related-work performing machine is a component mounter configured to perform, as the circuit-substrate-related work, a component mounting work for mounting electric components on the circuit substrate, and each of the mounted electric components is a work-subjected portion.
(10) The circuit-substrate-related-work assisting device according to the form (7) or (8), wherein the circuit-substrate-related-work performing machine is a solder printer configured to perform, as the circuit-substrate-related work, a solder printing work for printing solder cream on the circuit substrate, and each of lands of the printed solder is a work-subjected portion.
   In each of the above two forms, there are added a limitation relating to the kind of the circuit-substrate-related-work performing machine, the kind of the circuit-substrate-related work, and the work-subjected portions in the circuit-substrate-related work.
(11) A method of assisting a circuit-substrate-related work to be performed by a circuit-substrate-related-work performing machine on a circuit substrate that constitutes an electric circuit, the method comprising:
   a quality judging step of making a judgment as to a change in work quality of the circuit-substrate-related-work performing machine;
   an improvement-action determining step of determining an improvement action for improving the work quality where it is judged in the quality-judging step that a degree of deterioration of the work quality exceeds a prescribed degree;
   an action notifying step of notifying at least one of the circuit-substrate-related-work performing machine and an operator of the circuit-substrate-related-work performing machine of the improvement action determined in the improvement-action determining step; and
   an action-completion-information receiving step of receiving, from at least one of the circuit-substrate-related-work performing machine and the operator, action-completion information that is information as to completion of the improvement action notified in the action notifying step,
   wherein, in the quality judging step, it is judged whether the circuit substrate is the circuit substrate on which the circuit substrate related work was performed after implementation of the improvement action, and a judgment as to a change in the work quality before and after the completion of the improvement action is made conditionally on reception of the action-completion information in the action-completion-information receiving step,
      another improvement action different from the determined improvement action is determined where there are no signs of improvement in the work quality even though the determined improvement action has been implemented on the circuit-substrate-related-work performing machine, and
      the another improvement action is determined according to a priority order set in advance.

This form is a form of the claimable invention belonging to a category of a method, namely, a form of a circuit-substrate-related work assisting method (hereinafter simply referred to as "assisting method" where appropriate) relating to the claimable invention. Since the technical concept of this form is similar to that of the circuit-substrate-related-work assisting device described above relating to the claimable invention, its explanation is dispensed with. As for some of the above-indicated forms of the circuit-substrate-related-work assisting device, by replacing "portion" of the functional portion described in the forms (e.g., the condition-change recognizing "portion", the monitor-target-portion identifying "portion", etc.,) with "step" and permitting the forms to depend from this form, the forms may be some forms of the circuit-substrate-related work assisting method relating to the claimable invention.

### BRIEF DESCRIPTION OF DRAWINGS

Fig. 1 is a perspective view showing an electric-circuit-production assisting device as a circuit-substrate-related-work assisting device of one embodiment and an electric-circuit production line in which are disposed circuit-substrate-related-work performing machines that the assisting device assists.
Fig. 2 is a perspective view showing a solder printer disposed in the electric-circuit production line, in a state in which an external panel is removed therefrom.
Fig. 3 is a schematic view for explaining an inspection by a printing-work-result inspecting machine.
Fig. 4 is a perspective view showing an internal structure of a mounting module that constitutes a component mounter.
Figs. 5A-5C are perspective views showing various work heads attachable to the mounting module.
Fig. 6 is a flow chart showing a condition-change recognizing and monitor-target-portion identifying program executed in the electric-circuit-production assisting device.
Fig. 7 is a flow chart showing a quality-change judging and coping program executed in the electric-circuit-production assisting device.
Fig. 8 shows a definition formula of a process capability index C_{pK} as one kind of a stability index and a graph for explaining the process capability index C_{pK}.
Fig. 9 is a flow chart showing a quality improvement sub routine executed in the quality-change judging and coping program.
Fig. 10 is a block diagram showing a functional structure of the electric-circuit-production assisting device.

### DESCRIPTION OF EMBODIMENT

There will be hereinafter explained in detail a circuit-substrate-related-work assisting device and a circuit-substrate-related work assisting method according to one embodiment of the claimable invention and a modified example thereof, with reference to drawings. It is to be understood that the claimable invention may be embodied with various changes and modifications based on the knowledge of those skilled in the art, in addition to the following embodiment, the modified example, and various forms described in the FORMS OF INVENTION.

### DESCRIPTION OF EMBODIMENT

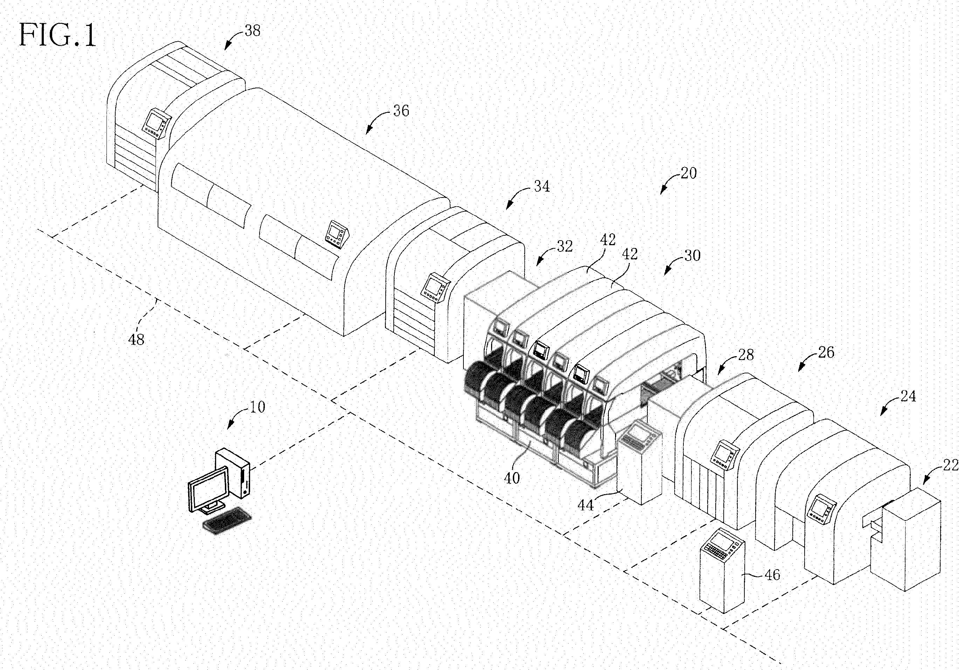

As shown in Fig. 1, an electric-circuit-production assisting device 10 (hereinafter simply referred to as "assisting device 10" where appropriate) as one kind of the circuit-substrate-related-work assisting device of the present embodiment is configured to assist production of electric circuits by an electric-circuit production line 20, more specifically, circuit-substrate-related works by circuit-substrate-related-work performing machines disposed in the electric-circuit production line 20. Hereinafter, there will be first explained the electric-circuit production line, then an outline of assisting processing by the assisting device 10 and some concrete examples of the assisting processing.

### 1. Electric-Circuit Production Line

### i) Overall Structure of Electric-Circuit Production Line

As shown in Fig. 1, the electric-circuit production line 20 (hereinafter simply referred to as "production line 20" where appropriate) is constituted by a substrate feeder 22, a solder printer 24, a printing-work-result inspecting machine 26, a first transfer-path changer 28, a component mounter 30, a second transfer-path changer 32, a mounting-work-result inspecting machine 34, a reflow furnace 36, and a final inspecting machine 38 which are disposed in the order of description from an upstream side. In the production line 20, a plurality of substrates successively pass through the machines, so that the electric circuits are produced. Each of the solder printer 24, the component mounter 30, and the reflow furnace 36 is the circuit-substrate-related-work performing machine, and a solder printing work, a component mounting work, a component fixing work respectively performed by the solder printer 24, the component mounter 30, and the reflow furnace 36 are the circuit-substrate-related works.

The above-indicated machines that constitute the production line 20 will be briefly explained. The substrate feeder 22 accommodates a plurality of substrates that are stacked and is configured to successively feed the substrates one by one to the production line 20, more specifically, to the solder printer 24. The solder printer 24 is configured to perform a work of screen-printing solder cream on the surface of each substrate fed from the substrate feeder 22 (i.e., a solder printing work). The printing-work-result inspecting machine 26 is configured to inspect a result of the solder printing work performed by the solder printer 24. As will be explained later in detail, the component mounter 30 is capable of performing a work using two lanes. The first transfer-path changer 28 has a function of distributing the substrates conveyed from the printing-work-result inspecting machine 26 to the two lanes of the component mounter 30. The component mounter 30 is constituted by one base 40, six mounting modules 42 which are arranged side by side on the base 40 and each of which functions as a component mounter, and a general module controller 44 configured to control the mounting modules 42 in a centralized manner. The component mounter 30 is configured such that a work of mounting components (a component mounting work) is performed by each of the six mounting modules 42 while the substrate on which the solder has been printed sequentially passes through the six mounting modules 42, so as to finish the component mounting work on the substrate. The second transfer-path changer 32 has a function of unifying paths of the substrate conveyed in the two lanes in the component mounter 30. The mounting-work-result inspecting machine 34 is configured to inspect a result of the component mounting work performed by the component mounter 30. The reflow furnace 36 is configured to perform a work of fixing the components to the substrate (a component fixing work) in which the substrate on which the components have been mounted is heated so as to melt the solder cream and thereafter the substrate is cooled to thereby solidify the solder. The final inspecting machine 38 is disposed at the end of the production line 20 and is configured to perform a final inspection of each of the produced electric circuits on which the circuit-substrate-related works performed by the above-indicated machines. The production line 20 has a line controller 46 configured to control the machines 24, 26, 30, 34, 36, 38 in a centralized manner. The line controller 46 is connected to the machines via a LAN 48. Further, the assisting device 10 is also connected to the LAN 48 and is connected to the machines 24, 26, 30, 34, 36, 38 and the line controller 46 via the LAN 48. There will be hereinafter explained in detail the principal machines individually.

### ii) Solder Printer

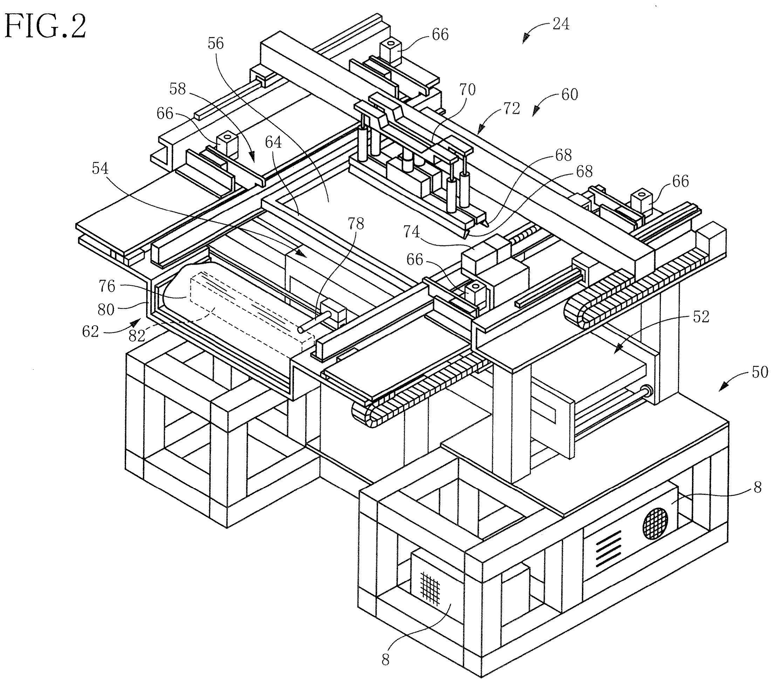

As shown in Fig. 2, the solder printer 24 has a base frame 50 mainly constituted by square pipes and is constituted by a substrate conveyor 52, a substrate holding and up-down moving device 54 (which is hidden by a screen 56 and only a part of which appears in Fig. 2), a screen holder 58, a squeegee device 60, a cleaning device 62, and so on, which are supported by the base frame 50.

The substrate conveyor 52 is configured to convey the substrate to a downstream side and to stop the substrate at a prescribed work position below the screen 56. The substrate holding and up-down moving device 54 is configured to hold the substrate located at the work position and to elevate and lower the substrate. The screen holder 58 includes a holder frame 64 that holds the screen 56 and four holder-frame adjusting mechanism 66 configured to perform a positional adjustment of the holder frame 64 so as to adjust a position of the screen 56. The squeegee device 60 is constituted by a squeegee unit 72 that includes a pair of squeegees 68 and a squeegee up-down mechanism 70 configured to move each of the squeegees 68 upward and downward, and a unit moving mechanism 74 configured to move the squeegee unit 72 frontward and backward to thereby move the pair of squeegees 68 frontward and backward.

The substrate conveyed from the upstream side by the substrate conveyor 52 is stopped at the work position and is subsequently held and elevated by the substrate holding and up-down moving device 54, so as be pushed on the lower surface of the screen 56. The screen 56 is formed with openings (through-holes) for forming solder lands (which are also called "solder pads"), and the solder cream is supplied on the upper surface of the screen 56. The squeegee unit 72 is moved by the unit moving mechanism 74 one of frontward and backward with only one of the squeegees 68 kept pushed on the upper surface of the screen 56, so that the solder cream supplied on the upper surface of the screen 56 passes through the openings of the screen 56 and is attached to the upper surface of the substrate that is pushed on the lower surface of the screen 56. In this way, the solder lands are formed on the upper surface of the substrate in a certain land pattern defined by the openings. Thus, the solder printing work on the substrate is finished. After the substrate that has been subjected to the solder printing work is lowered by the substrate holding and up-down moving device 54, the substrate is released from the holding by the substrate holding and up-down moving device 54 and is subsequently conveyed to the downstream side by the substrate conveyor 52. Thus, the solder printing work on one substrate is performed in the solder printer.

In the solder printing work, the screen 56 and the substrate held by the substrate holding and up-down moving device 54 are positioned relative to each other. While not shown, the solder printer 24 has an image taking device configured to take images of both of the lower surface of the screen 56 and the upper surface of the substrate by moving between the screen 56 and the substrate before elevated. The image taking device is configured to take images of a substrate fiducial mark attached to the upper surface of the substrate and a screen fiducial mark attached to the lower surface of the screen 56. On the basis of image data obtained by the image taking, a relative positional deviation amount of the substrate and the screen 56 is obtained. On the basis of the obtained relative positional deviation amount, the position of the screen 56 is adjusted by the holder-frame adjusting mechanisms 66. Thereafter, the substrate is elevated by the substrate holding and up-down moving device 54 and is subjected to the solder printing work.

The cleaning device 62 is for cleaning the lower surface of the screen 56 in a case in which there occurs insufficiency or excess in the area or the volume of the solder lands such as thin spots or expansions thereof. The cleaning device 62 includes a cleaning unit 80 that includes: nonwoven fabric 76 wound around and stretched between a pair of rollers; and a nozzle 78 by which the nonwoven fabric 76 is impregnated with alcohol as a cleaning liquid. The cleaning unit 80 is configured to be moved frontward and backward by a unit moving mechanism (that is hidden in Fig. 2). The cleaning unit 80 is moved by the unit moving mechanism with the nonwoven fabric 76 held in contact with the lower surface of the screen 56, whereby the lower surface of the screen 56 is wiped with the nonwoven fabric 76 for cleaning. Below the nonwoven fabric 76, there is provided a backup member 82 for backing the nonwoven fabric 76, and the nonwoven fabric 76 is brought into contact with the lower surface of the screen 56 while being backed by the backup member 82. In the cleaning unit 80, there is provided a vacuum suction device not shown by which substances adhering to the screen 56 can be sucked via a slot formed in the backup member 82 and the nonwoven fabric 76. The cleaning by the cleaning device 62 can be performed in one of the following three modes: dry cleaning that does not involve impregnation of the nonwoven fabric 76 with alcohol and suction by the suction device: wet cleaning that involves impregnation with alcohol; and vacuum cleaning that involves impregnation with alcohol and suction. Any one of the three modes is selected, and the lower surface of the screen 56 is cleaned in the selected mode. The cleaning device 62 is configured to start the cleaning automatically on a regular basis, automatically based on a signal inputted from the exterior, or manually by an operation of the operator.

The solder printer 24 includes a controller 84 constituted principally by a computer. Various devices and mechanisms indicated above that constitute the solder printer 24 are controlled by the controller 84. The controller 84 grasps and manages the solder cream that is currently supplied, on the basis of a solder ID inputted by an operation on the operation panel by the operator. The solder printer 24 further has an air conditioner 86 configured to adjust the inner temperature of the solder printer 24 for adjusting the viscosity, etc., of the solder cream supplied on the upper surface of the screen 56.

### iii) Printing-Work-Result Inspecting Machine

The printing-work-result inspecting machine 26 includes a substrate conveyor, an inspecting head, and a head moving device configured to move the inspecting head though an internal structure of the printing-work-result inspecting machine 26 is not illustrated. The substrate conveyor has a function of conveying the solder-printed substrate from the upstream side into the inspecting machine 26 and conveying the substrate to the downstream side out of the inspecting machine 26 and a function of keeping the substrate in place at a predetermined inspection position. The inspecting head is a work head for obtaining information as to the surface of the substrate kept in place at the inspection position. The head moving device is the so-called X-Y type moving device and includes: an X-direction moving mechanism configured to move the inspecting head in a direction (X direction) parallel to a substrate conveyance direction; and Y-direction moving mechanism configured to move the X-direction moving mechanism in a direction (Y direction) perpendicular to the X direction. The head moving device is configured to move the inspecting head above the substrate along one plane that is parallel to the surface of the substrate.

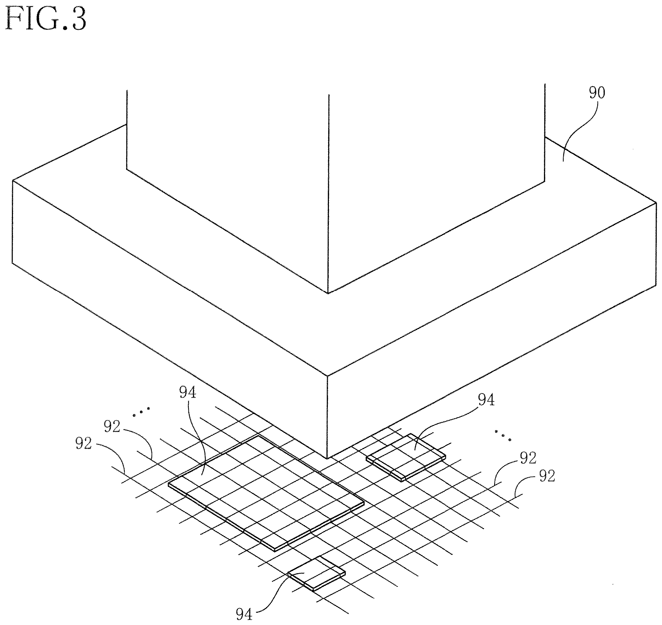

After the solder printing work, there are formed, on the surface of the substrate, a plurality of solder lands (that may be also called "solder pads") each as a work-subjected portion. While a detailed explanation is omitted, the inspecting head is a printing-result inspecting head 90 configured to inspect a result of the solder printing work, as schematically shown in Fig. 3. The printing-result inspecting head 90 includes: a light source for applying a slit light obliquely from for different directions so as to form a grid on the surface of the substrate; and a camera as an image taking device for taking an image of the light grid formed on the surface of the substrate obliquely from two directions. In one light line 92 constituting the grid formed by the applied slit light, a part of the light line 92 formed on one solder land 94, namely, formed on a portion of the substrate on which the solder is printed, is shifted from another part of the light line 92 formed on the surface of the substrate on which no solder pads 94 are formed. The amount of the shift varies depending on the thickness (height) of the one solder land. The image data obtained by the camera is processed utilizing the principle described above, and the printing-work-result inspecting machine 26 obtains, for the solder land 94, positional deviation amounts in the X direction and the Y direction, a positional deviation amount in a rotational direction (a deviation amount in a rotational angle or an orientation), an area, and a volume. The camera is capable of taking an image of a plurality of solder lands 94 such that the plurality of solder lands 94 are included in one field of view. Accordingly, the printing-work-result inspecting machine 26 is capable of inspecting a plurality of solder lands 94 at one time.

Where the above-indicated deviation amount for a certain solder land 94, any of an area change amount for the solder land 94 that is a change amount of the area from a normal area and a volume change amount for the solder land 94 that is a change amount of the volume from a normal volume exceeds a limit value set for the solder land 94 (i.e., a limit value for failure judgment), the printing-work-result inspecting machine 26 identifies the certain solder land 94 as a failure portion and notifies the operator of print failure information as to the work-subjected portion identified as the failure portion, details of the failure, and so on, through a display or the like of the operation panel. The operator performs, on the basis of the notified information, a change of conditions under which the solder printing work by the solder printer 24 is performed, such as a change of programs, a change of the temperature, an additional supply of the solder, and cleaning of the screen 56 by the cleaning device 62.

### iv) Component Mounter

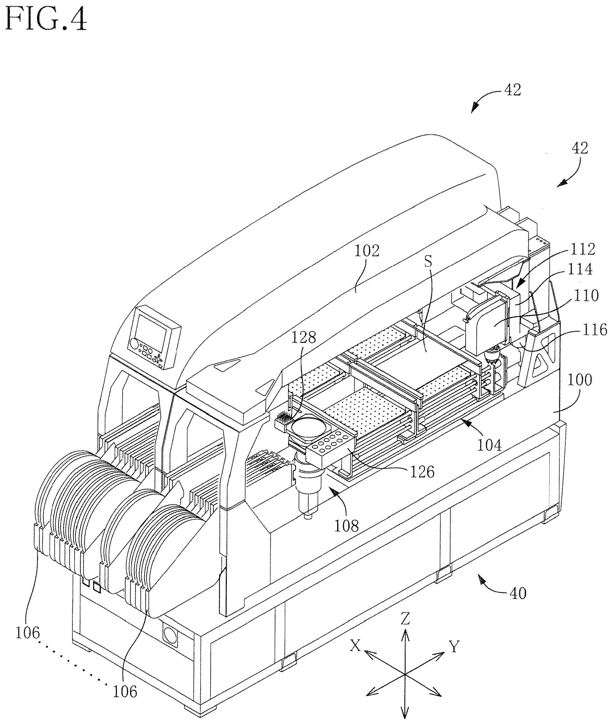

The component mounter 30 is a work machine for mounting components on the substrate and is constituted by the base 40, the six mounting modules 42, and the general module controller 44 as described above. Fig. 4 shows the mounting module 42 from which an external panel is removed. As shown in Fig. 4, the mounting module 42 includes: a module base 100; a beam 102 disposed above the module base 100; a substrate conveyor 104 provided on the module base 100; a plurality of component feeders 106, each as a component supply device, that are replaceably attached to the module base 100 on a front side of the mounting module 42; a component camera 108 of a base-fixed type that is fixed to the module base 10 between the substrate conveyor 104 and the plurality of component feeders 106; a mounting head 110 (as one kind of the work head) configured to hold a component fed from any one of the plurality of component feeders 106 and to release the component for mounting on a substrate S; and a head moving device 112 provided on the beam 102 so as to move the mounting head 110.

The substrate conveyor 104 has two tracks (two lanes) on which the substrates are conveyed. The substrates are conveyed into each of the tracks from the upstream side and are conveyed out of the tracks to the downstream side. The substrate conveyor 104 has support tables below the respective tracks that are capable of moving upward and downward. The substrate S conveyed to a predetermined position is fixed at the position by the support table that moved upward. That is, the substrate conveyor 104 functions in the component mounting work as a substrate fixation device configured to fix the substrate S at a predetermined work position. Because the substrate conveyor 104 is disposed in each of the mounting modules 42, the component mounter 30 is capable of performing the component mounting work in the two lanes. Here, a substrate conveyance direction in which the substrates are conveyed by the substrate conveyor 104 is an X direction in Fig. 4 (illustrated together with a Y direction and a Z direction).

The head moving device 112 is the so-called X-Y type moving device and includes: a head attachment member 114 to which the mounting head 110 is detachably attached; an X-direction moving mechanism configured to move the head attachment member 114 in the X direction; and a Y-direction moving mechanism supported by the beam 102 and configured to move the X-direction moving mechanism such that the mounting head 110 is moved between the component feeder 106 and the substrate S. A substrate camera 116 for taking an image of the surface of the substrate S is fixed below the head attachment member 114.

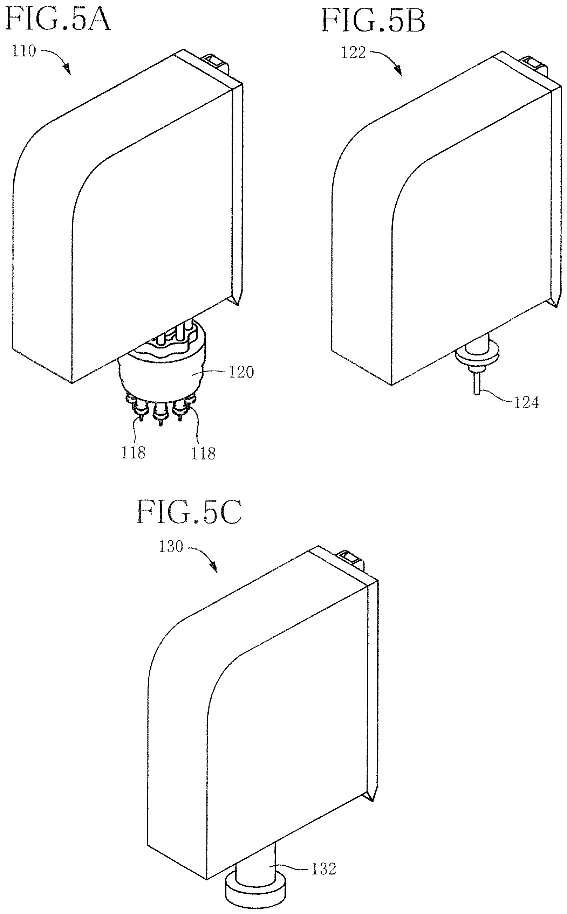

The mounting head 110 is of the so-called index type. As shown in Fig. 5A, the mounting head 110 has eight suction nozzle 118 each functioning as a component holding device and each configured to suction-hold, at its lower end portion, the component by a negative pressure applied thereto, i.e., a pressure reduced at a level lower than the atmospheric pressure. The eight suction nozzles 118 are held by a revolver 120. The revolver 120 is configured to intermittently rotate so as to enable one suction nozzle 118 located at a specific position to be moved, by a nozzle up-down mechanism, upward and downward, namely, in the up-down direction (the Z direction). The suction nozzle 118 located at the specific position is configured to hold the component by the negative pressure applied thereto when moved downward and to release the suction-held component when the application of the negative pressure is stopped. Each of the eight suction nozzle 118 is configured to be rotated, by a nozzle rotating mechanism, about an axis thereof (hereinafter referred to as "nozzle axis" where appropriate), namely, to be rotated about the nozzle axis as a center of rotation, and the mounting head 110 is capable of changing and adjusting a rotational position of the component held by each suction nozzle 118 (that may be also referred to as "rotational posture" or "orientation").

In each of the component feeders 106, there are set reels around each of which a component holding tape is wound. (The component holding tape holds a plurality of components thereon and may be referred to as "taped components".) Each component feeder 106 is configured to intermittently feed the component holding tape, whereby the components are sequentially supplied one by one at a predetermined component-supply position. Replenishment of the components may be carried out by splicing or coupling additional taped components to the existing taped components while changing reels or by replacing the component feeder 106 in its entirety inclusive the reels. The mounting module 42 is configured such that the so-called tray-type component supply device is attachable in place of the plurality of component feeders 106. The components are managed by a component ID, and each mounting module 42 grasps, owing to its controller, which components are supplied thereto.

The component mounting work by one mounting module 42 will be explained. Initially, the substrate S to be subjected to the component mounting work is conveyed into the mounting module 42 by the substrate conveyor 104 from the upstream side and is fixed at a predetermined work position. Subsequently, the substrate camera 116 is moved by the head moving device 112 so as to take an image of the fiducial mark attached to the upper surface of the substrate S. On the basis of image data obtained by the image taking, there is determined a coordinate system as a base of the mount position of each component. Then the mounting head 110 is moved by the head moving device 112 to above the plurality of component feeders 106, and the components are sequentially held by the respective eight suction nozzles 118. The mounting head 110 passes over the component camera 108 in a movement to above the substrate S, so that images of the components held by the respective suction nozzles 118 are taken by the component camera 108. On the basis of the image data, there is grasped a positional deviation amount (that is a concept including a rotational-position deviation) of each component relative to the nozzle axis. Subsequently, the mounting head 110 is moved so as to be located above the substrate S, and each of the components is mounted to a predetermined position set by a mount program while correction based on the above-indicated positional deviation amount is conducted. The mounting head 110 is reciprocated between the component feeder 106 and the substrate S the number of times set by the mount program, and the holding and the mounting of the components by the mounting head 110 are repeated as described above, whereby the component mounting work by one mounting module 42 is completed. When one substrate S passes through the six mounting modules 42, the above-indicated component mounting work on the one substrate S by each of the six mounting modules 42 is sequentially performed, so that the mounting work by the component mounter 30 on the one substrate is completed. In the component mounting work, when the suction nozzles 118 suction-hold the components from the plurality of component feeders 106, the suction nozzles 118 may sometimes make an error, namely, may sometimes fail to suction-hold the components. In an instance where such a suction-holding error occurs, it is possible to recover from the error by permitting the same suction nozzle 118 that made the error to again suction-hold the component from the same component feeder 106. In this respect, the number of the suction-holding errors is counted for every component and for every suction nozzle 118.

Each mounting module 42 is configured such that the mounting head 110 is replaced with other work head. For instance, a mounting head 122 shown in Fig. 5B is attachable. The mounting head 122 is of the so-called single-nozzle type. The mounting head 122 has only one suction nozzle 124 as the component holding device. Though the mounting head 122 can suction-hold only one component at one time, a relatively large-sized component can be suction-held by the mounting head 122. The mounting head 122 also has the nozzle up-down mechanism and the nozzle rotating mechanism. The suction nozzle 124 is configured to be moved upward and downward when the component is held and released and to be rotated about the nozzle axis for changing and adjusting the rotational position of the component. The eight suction nozzles 118 of the mounting head 110 and the suction nozzle 124 of the mounting head 122 are automatically replaceable, and the suction nozzles 118, 124 for replacement are accommodated in a nozzle stocker 126 disposed between the substrate conveyor 104 and the component feeders 106. A nozzle cleaner 128 is disposed at a position in the X direction at which the component camera 108 is sandwiched by and between the nozzle cleaner 128 and the nozzle stocker 126. The nozzle cleaner 128 is constituted by a brush as a main constituent element. The mounting head 110, 122 is moved by the head moving device 112 with the lower end of each suction nozzle 118, 124 kept in contact with the brush, whereby foreign substances and the like adhering to the suction nozzles 118, 124 are removed. A nozzle ID is given to each suction nozzle 118, 124 while a head ID is given to each mounting head 110, 122, and each mounting module 42 has a function of recognizing the nozzle ID and the head ID, so as to grasp the suction nozzle and the work head that are being used in the current component mounting work thereof.

Each mounting module 42 is configured such that an inspecting head 130 shown in Fig. 5C is attachable in place of the mounting head 110. The inspecting head 130 has a substrate camera 132, as an image taking device, capable of taking an image of the surface of the substrate S. The substrate camera 132 has a relatively large field of view and is capable of taking an image of a plurality of components mounted on the substrate S such that the plurality of components are included in one field of view. The substrate camera 132 has relatively high resolution. Accordingly, the substrate camera 132 is suitable for an inspection as to a deviation, etc., of the mounted component from the mount position. (In this sense, the substrate camera 132 may be referred to as "inspecting camera 132" where appropriate. The mounting module 42 to which the inspecting head 130 is attached has a function similar to that of the mounting-work-result inspecting machine 34 disposed on the downstream side of the component mounter 30, in other words, the mounting module 42 functions as an inspecting module. Where the number of the components each as the inspection target is large, namely, where the number of the work-subjected portions is large, for instance, the inspection work for inspecting the mount result takes too much time if the inspection work is performed by only the inspecting machine 34. In such an instance, by attaching the inspecting head 130 to the most downstream one of the six mounting modules 42 and permitting the mounting module 42 in question to function as the mounting-work-result inspecting machine in addition to the mounting-work-result inspecting machine 34, for instance, it is possible to suppress a reduction in productivity of the electric-circuit production line that arises from an increased inspection time. The replacement of the work heads 110, 122, 130 can be carried out with one-touch action by a lever operation.

The mounting modules 42 are distinguished from one another by a module ID, and the general module controller 44 recognizes which mounting module 42 is disposed at which position on the base 40, by grasping the module ID.

### v) Mounting-Work-Result Inspecting Machine

Like the printing-work-result inspecting machine 26, the mounting-work-result inspecting machine 34 includes a substrate conveyor, an inspecting head, and a head moving device configured to move the inspecting head though an internal structure of the mounting-work-result inspecting machine 34 is not illustrated. The substrate conveyor has a function of conveying the component-mounted substrate from the upstream side into the inspecting machine 34 and conveying the substrate to the downstream side out of the inspecting machine 34 and a function of keeping the substrate in place at a predetermined inspection position. While the substrate conveyor and the head moving device have respective structures similar to structures of those in the printing-work-result inspecting machine 26, the inspecting head in the mounting-work-result inspecting machine 34 differs in structure from the inspecting head in the printing-work-result inspecting machine 26. The inspecting head in the mounting-work-result inspecting machine 34, namely, a mounting-result inspecting head, is constituted, as a principal constituent element, by a substrate camera as an image taking device for taking images of the surface of the substrate and the upper surface of the component mounted on the substrate from above. Owing to the substrate camera, two-dimensional image data is obtained.

By the component mounting work, a large number of the components are mounted on the substrate, and each of those components is the work-subjected portion. On the basis of the image data obtained by the substrate camera of the mount-result inspecting head, the mounting-work-result inspecting machine 34 obtains, for each component, positional deviation amounts in the X direction and the Y direction and a deviation amount in a rotational direction (a deviation amount in a rotational angle or an orientation), with regard to the mount position, and inspects for any occurrence of a lack of the component or a component standing phenomenon (i.e., the so-called chip standing phenomenon). Where it is confirmed that the lack of the component or the component standing phenomenon has occurred, it is identified, based on the fact of the occurrence, that the work-subjected portion suffers from a work failure, namely, the work-subjected portion is a failure portion. Concerning a positional deviation of the mount position, in an instance where any of the above-indicated deviation amounts of a certain component exceeds a limit value set for the component (i.e., a limit value for failure judgment), the mounting-work-result inspecting machine 34 identifies the component, namely, the work-subjected portion, as the failure portion. Where the work failure is identified, the mounting-work-result inspecting machine 34 notifies the operator of mount failure information as to the failure portion, details of the work failure, and so on, through the display or the like of the operation panel. The operator carries out, on the basis of the notified information, a change in conditions under which the component mounting work by the component mounter 30 is performed (such as a change of programs relating to a positional-deviation correction amount), replacement of the suction nozzles, the components to be supplied, and so on. Like the camera of the printing-result inspecting head 90 in the printing-work-result inspecting machine 26 and the substrate camera 132 of the inspecting head 130 attached to the component mounter 30, the substrate camera of the mounting-work-result inspecting machine 34 is capable of taking an image of a plurality of the work-subjected portions (the mounted components) such that the plurality of the work-subjected portions are included in one field of view. Accordingly, the mounting-work-result inspecting machine 34 is capable of inspecting a work result of the plurality of components at one time.

### vi) Reflow Furnace

The reflow furnace 36 includes a conveyor configured to convey the substrate that has been conveyed into the reflow furnace 36 from the mounting-work-result inspecting machine 34, i.e., the substrate on which the components have been mounted, to an outlet, and a heater of a hot-air type, an infrared-type, or the like, for heating the substrate. The component-mounted substrate is heated by the heater while being conveyed by the conveyor, and the solder cream is melted and cooled (natural cooling) in the neighborhood of the outlet. As a result, the solder is solidified, and the components are fixed. The conveyance speed of the substrate by the conveyor device, the temperature profile in the furnace (the state of the change in the heating temperature of the substrate relative to a change in the conveyance position when the substrate is conveyed in the furnace) and so on can be arbitrarily set depending on the size of the circuit to be produced, the number of the components, the kind of the solder cream, etc.

### vii) Final Inspecting machine

The final inspecting machine 38 has a construction similar to that of the mounting-work-result inspecting machine 34. On the basis of the image data obtained by the substrate camera of the inspecting head, the final inspecting machine 38 obtains, for the component, positional deviation amounts in the X direction and the Y direction and a deviation amount in a rotational direction (a deviation amount in a rotational angle or an orientation), with regard to the component fixation position, and inspects for any occurrence of a lack of the component, or a component standing phenomenon (i.e., the so-called chip standing phenomenon). Where it is confirmed that the lack of the component or the component standing phenomenon has occurred, it is identified, based on the fact of the occurrence, that the work-subjected portion suffers from a work failure, namely, the work-subjected portion is a failure portion. Concerning a positional deviation of the component fixation position, in an instance where any of the above-identified deviation amounts of a certain component exceeds a limit value set for the component (i.e., a limit value for failure judgment), the final inspecting machine 38 identifies the component, namely, the work-subjected portion, as the failure portion. In addition, the final inspecting machine 38 performs an inspection about the solidified solder. To be more specific, on the basis of the image data indicated above, the final inspecting machine 38 inspects for any difference of an outer dimension of each of the solder lands on which the components are placed, from a normal outer dimension (i.e., a change amount in the outer dimension), briefly, a failure in the shape of the solder lands. In an instance where the solder flows and the area of the solder land becomes excessive, for instance, the solder land is connected to another solder land adjacent thereto, causing a short circuit of the electric circuit. The outer shape of each solder land is inspected from such a viewpoint. Where the two solder lands contact each other, it is identified that the solder lands are failure portions. Failure information such as the failure portions and details of the work failure is notified to the operator through the display or the like of the operation panel. The operator adjusts the conveyance speed and the temperature profile in the reflow furnace 36 on the basis of the notified information. The failure with regard to the component fixation position may be caused by not only the failure in the component fixing work by the reflow furnace 36, but also a reduction in the work quality of the component mounting work by the component mounter 30. Accordingly, in this sense, the final inspecting machine 38 functions as an inspecting machine for inspecting not only the work result of the component fixing work by the reflow furnace 36, but also the result of the mounting work by the component mounter 30. That is, the final inspecting machine 38 functions as both of a mounting-work-result inspecting machine and a fixing-work-result inspecting machine.

### viii) Line Controller

The line controller 46 is a control device having, as a main function, a function of controlling the production line 20 in a centralized manner. The line controller 46 is configured to grasp the substrates on which the works are being performed by machines at a current time point, to manage a planned production number and an actual production number of the electric circuits in the production line 20, and a production tact of the production line 20, etc., and to perform setting processing by an inputting operation by the operator as to setting items common to the machines. Each machine has a function of recognizing substrate IDs of the substrates on which the machine is currently performing the work. Each machine grasps the substrate IDs of the substrates on which the machine performs the circuit-substrate-related work, and the line controller 46 manages the substrates passing in the production line 20, on the basis of substrate ID information from each machine. In addition to such functions, the line controller 46 has a function of managing the operator and grasps who is currently the operator of the production line 20 on the basis of an operator ID inputted by the operator.

### 2. Outline of Assisting Processing by Electric-Circuit-Production Assisting Device

The electric-circuit-production assisting device 10 is realized by execution of a particular program by a general-purpose computer and is configured to assist in a quality aspect of the electric circuits produced by the production line 20. To be more specific, the work failures of the circuit-substrate-related works of the respective solder printer 24, component mounter 30, and reflow furnace 36, each as the circuit-substrate-related-work performing machine, are detected by the printing-work-result inspecting machine 26, the mounting-work-result inspecting machine 34, and the final inspecting machine 38, as explained above. Accordingly, the present assisting device 10 performs assisting processing to grasp quality deterioration that does not reach a level to be identified as a failure, so as to maintain high reliability in the quality of the electric circuits to be produced. For efficiently executing the assisting processing, where a work-condition change occurs in any circuit-substrate-related-work performing machine, the assisting device 10 monitors quality deterioration in the work-subjected portions relating to the work-condition change. To this end, the assisting processing performed by the assisting device 10 mainly incudes: two sorts of processing, i.e., condition-change recognizing and monitor-target-portion identifying processing for recognizing the work-condition change and identifying the work-subjected portions each as a monitor target and quality-change judging and coping processing for making a judgment as to a change in the work quality for the identified work-subjected portions and coping with the quality deterioration where the quality deterioration occurs; and a quality improvement processing executed in the quality-change judging and coping processing. There will be first explained information and data utilized in the three sorts of processing and then the three sorts of processing in order. Thereafter, the functional structure of the assisting device 10 will be explained.

### [A] Information and Data Utilized in Assisting Processing

Information and data utilized in the assisting processing are generally classified into two sorts. One is "machine-related information" for recognizing the work-condition change and the other is "comparison data upon quality-deterioration judgment" (hereinafter simply referred to as "the comparison data" where appropriate) to be compared for judging the quality deterioration. In this respect, the information and the data are stored in an information and data storage portion of the assisting device 10 when the assisting processing is performed. The information and the data will be explained in order.

### i) Machine-Related Information

In brief, the machine-related information indicates, in an instance where the circuit-substrate-related-work performing machine performed the circuit-substrate-related work on one substrate, what devices and material were used, what operations were performed, how the state of the machine was, etc. The machine-related information can be further classified in two sorts. One is information as to an actually performed work by the circuit-substrate-related-work performing machine (i.e., work performance information) and the other is information as to an actually implemented action on the circuit-substrate-related-work performing machine (i.e., action information). The machine-related information is mainly sent from the circuit-substrate-related-work performing machine to the assisting device every time the circuit-substrate-related-work performing machine has completed the circuit-substrate-related work on one substrate. The above-indicated information as to the operator is also one sort of the machine-related information and is sent from the line controller 46.

Concrete examples of the work performance information will be listed. The work performance information relating to the solder printer 24 includes a type, a lot number, a supplier (a vendor) of the solder cream that can be identified from a solder ID and that is being currently supplied, IDs of various devices that the solder printer 24 grasps, such as a screen ID, a squeegee ID, information as to the motion of the squeegees in the solder printing such as an application force to the screen of the squeegee device and the speed of the squeegees, a separation speed of the screen 56 from the substrate, and the temperature and the humidity in the machine. In a broad sense, information obtained from the image data of the substrate fiducial mark by the image taking device is included in the work performance information. The work performance information relating to the component mounter 30 includes a type, a lot number, a supplier of the components that can be identified from a component ID and that is being currently supplied, IDs of various devices that the component mounter 30 grasps, such as a component feeder ID, a tray ID, a nozzle ID, a head ID, a module ID, operation speeds of various devices such as a lowering speed of the nozzle in the mounting operation, and the mount positions of the components set in the mount program. Further, in a broad sense, information obtained from the image data of the substrate fiducial mark by the substrate camera 116 and information obtained from the image data of the component suction-held by the suction nozzle 118, 124 by the component camera 108 (such as the positional deviation of the component relative to the nozzle axis and the number of suction errors for every component or nozzle) are also included in the work performance information. The work performance information relating to the reflow furnace 36 includes the set conveyance speed of the substrate and the set temperature profile. In short, the work performance information may be regarded as information from which the work-condition change can be grasped, by comparing the work performance information about the circuit-substrate-related work on one substrate with the work performance information about the circuit-substrate-related work on another one substrate.

Concrete examples of the action information will be listed. The action information relating to the solder printer 24 includes, for instance, a fact that action was implemented such as an additional supply of the solder cream, replacement of various devices, and a change in the operation program of the solder printer, a fact that cleaning was performed on the screen 56 and the mode of the performed cleaning. The action information relating to the component mounter 30 includes, for instance, information as to a fact that the components were additionally supplied, a fact that various devices (such as the nozzles, the heads, and the modules) were replaced, and a fact that the mount program (such as the mount position) was changed. The action information relating to the reflow furnace 36 includes, for instance, information as to a fact that the conveyance speed of the substrate was changed and a fact that the temperature profile was changed. In short, the action information may be regarded as information directly indicating that the action invoking the work-condition change was actually implemented.

### ii) Comparison Data upon Quality-Deterioration Judgment

The comparison data includes at least one of operation-based data and inspection data. As explained above, the operation-based data includes various sorts of data that is detectable, measureable, and recognizable in the circuit-substrate-related-work performing machine, such as data relating to the operation necessary when the circuit-substrate-related-work performing machine performs the circuit-substrate-related work, data relating to the status of the circuit-substrate-related-work performing machine when the circuit-substrate-related-work performing machine is performing the operation or after the circuit-substrate-related-work performing machine performed the operation, and data relating to the movement and the status of the operation target object. Most of the work performance information explained above can be treated as the operation-based data. To be more specific, various data can be the operation-based data for the solder printer 24 such as data relating to the application pressure (the printing pressure) to the screen of the squeegee device and data relating to a deviation of the substrate fiducial mark obtained from the image data of the mark by the image taking device. Various data can be the operation-based data for the component mounter 30 such as data obtained from the image data, by the component camera 108, of the component suction-held by the suction nozzle 118, 124 (such as data relating to the positional deviation of the component relative to the nozzle axis), the number and the probability of suction errors for every component or every suction nozzle, and data relating to a deviation of the substrate fiducial mark obtained from the image data of the mark by the substrate camera 116. Various data can be the operation-based data for the reflow furnace 36 such as the conveyance speed of the substrate and the temperature profile in the furnace. The operation-based data indicated above is sent from the circuit-substrate-related-work performing machines to the assisting device 10 every time the circuit-substrate-related-work performing machines performed the respective circuit-substrate-related works.

The inspection data includes inspection data by the inspecting machines, specifically, by the printing-work-result inspecting machine 26, the mounting-work-result inspecting machine 34, and the final inspecting machine 38, configured to inspect the work result of the circuit-substrate-related work for the work-subjected portions on which the circuit-substrate-related work was performed. In some cases, the inspection data includes inspection data by the mounting module 42 functioning as the inspecting module. The inspection data is sent from the inspecting machine to the assisting device 10 every time each inspecting machine made an inspection for one substrate. Because the comparison data is referred to for judging a reduction in the work quality of the work-subjected portions, it is desirable that the comparison data be for each of a considerably large number of the substrates. Accordingly, the information and data storage portion of the assisting device 10 is configured to store the comparison data for a considerably large number of the substrates that are to be successively produced or were successively produced. Concrete examples of the inspection data will be listed below. The inspection data for the printing-work-result inspecting machine 26 includes, for instance, the deviation amount of the print position, the area change amount, the volume change amount and so on of each solder land. The inspection data for the mounting-work-result inspecting machine 34 includes, for instance, the deviation amount of the mount position of each component. The inspection data for the final inspecting machine 38 includes, for instance, the deviation amount of the fixation position of each component and the change amount in the outer dimension of each solder land.

### [B] Condition- Change Recognizing and Monitor-Target-Portion Identifying Processing

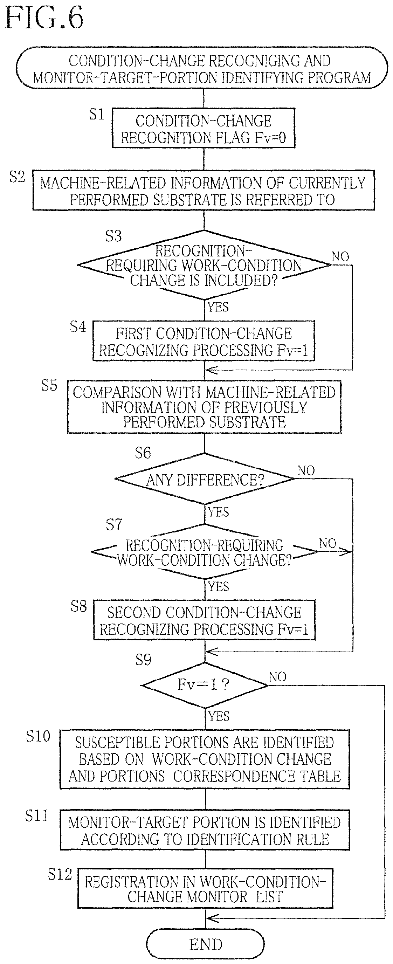

The condition-change recognizing and monitor-target-portion identifying processing is executed by execution of a condition-change recognizing and monitor-target-portion identifying program indicated by a flow chart of Fig. 6. This program is initiated by being triggered by completion of the circuit-substrate-related work on one substrate by any of the circuit-substrate-related-work performing machines. Irrespective of whether the circuit-substrate-related-work performing machine is any one of the solder printer 24, the component mounter 30, and the reflow furnace 36, there is executed processing in accordance with the circuit-substrate-related-work performing machine by execution of the program.

The processing will be explained referring to the flow chart. In the processing, initially at step 1 (hereinafter abbreviated as "S1" and other steps will be similarly abbreviated), a condition-change recognition flag Fv is reset to "0". This flag Fv is set to "1" when the assisting device 10 recognizes a work-condition change. Subsequently, at S2, there is referred to the machine-related information of a substrate on which a current circuit-substrate-related work was performed (hereinafter referred to as "currently performed substrate" where appropriate). The machine-related information is sent from the circuit-substrate-related-work performing machine, etc., and is stored in a machine-related information buffer of the information and data storage portion. Then, if, at S3, the machine-related information of the currently performed substrate, specifically, the above-indicated action information, includes information to the effect that there was actually implemented an action that caused a work-condition change to be recognized (i.e., recognition-requiring work-condition change), the condition-change recognition flag Fv is set to "1" at S4 as first condition-change recognizing processing. If not included, the first condition-change recognizing processing is skipped, and the control flow proceeds to S5.

At S5, the machine-related information of the currently performed substrate is compared with the machine-related information of a substrate on which a previous circuit-substrate-related work was performed (hereinafter referred to as "previously performed substrate"), the machine-related information of the preceding substrate being already stored in the machine-related information buffer. More specifically, the work performance information of the currently performed substrate and the work performance information of the previously performed substrate are compared with each other. Subsequently, it is judged at S6 whether there is any difference between the information. If it is judged that there is a difference, it is judged at S7 whether the difference arises from the recognition-requiring work-condition change. If the difference arises from the recognition-requiring work-condition change, the condition-change recognition flag Fv is set to "1" at S8 as second condition-change recognizing processing. If it is judged that there is no difference or if it is judged that, even if there is a difference, the difference does not arise from the recognition-requiring work-condition change, the second condition-change recognizing processing is skipped. The judgment as to whether the difference arises from the recognition-requiring work-condition change is made based on the kinds of the work performance information to be compared, the degree of the difference, and so on. In this instance, it is possible to make the judgment on the basis of information as to the operator included in the machine-related information, namely, on the basis of the talent, the ability, the skill, etc., of the operator. In the assisting device 10, it is judged for the presence or absence of the work-condition change to be recognized, namely, to be coped with, in the circuit-substrate-related work on the currently performed substrate, on the basis of the two sorts of the machine-related information.

If the judgment as to whether the recognition-requiring work-condition change occurred in the circuit-substrate-related work on the currently performed substrate is made at S9 based on the condition-change recognition flag Fv and it is finally judged that the recognition-requiring work-condition change occurred, the control flow proceeds to S10 and subsequent steps. At S10, there are specified, by referring to a work-condition change and portions correspondence table, work-subjected portions that will be susceptible to the work-condition change in terms of the work quality, namely, susceptible portions, on the basis of the machine-related information. The table is data in the form of a list indicating which work-subjected portions are susceptible to a certain work-condition change. The table is set in advance and is stored in the information and data storage portion. Subsequently, at S11, at least one monitor-target portion is identified from among the susceptible portions according to an identification rule set in advance. This rule is stored in the information and data storage portion. In some cases, all of the susceptible portions are identified as the monitor-target portion. However, when narrowing down is carried out, there may be employed, as the identification rule, a rule that is set by considering ease with which an influence of the work-condition change on the work quality appears, and the monitor-target portion may be identified according to the rule. After the monitor-target portion was identified, the work-condition change is registered at S12 in a work-condition-change monitor list that is set in a certain region of the information and data storage portion, together with data relating to the work-condition change (i.e., condition-change related data) such as the substrate ID of the currently performed substrate and data as to the identified monitor-target portion. In the quality-change judging and coping processing that will be explained later, processing that relates to the work-condition change is executed as one processing target for each work-condition change. Accordingly, the work-condition-change monitor list is provided for specifying the work-condition change as the processing target, and a certain work-condition change and condition-change related data associated therewith are stored for each work-condition change as set data of one processing target. The registered work-condition change is not erased in principle until it is judged that no quality deterioration due to a certain work-condition change occurred or until the quality is improved by the improvement action even if the quality deterioration occurred. As a result of completion of S12, a series of processing according to the program for one substrate on which the circuit-substrate-related work was performed ends. If it is judged at S9 that the recognition-requiring work-condition change did not occur in the circuit-substrate-related work on the currently performed substrate, S10 and subsequent steps are skipped, and a series of processing according to the program ends.

### [C] Quality-Change Judging and Coping Processing

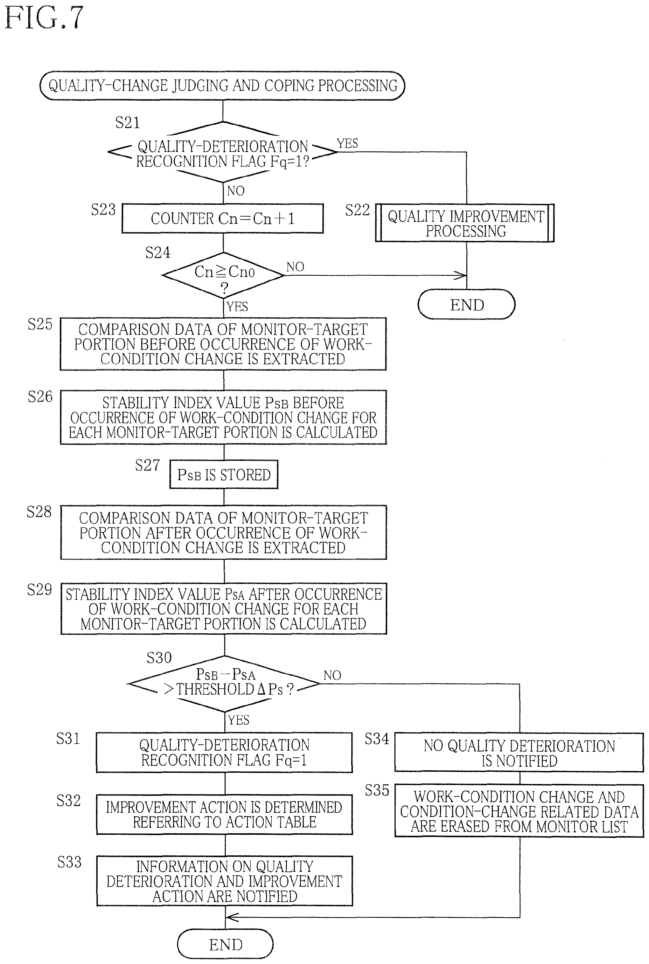

The quality-change judging and coping processing is executed by execution of a quality-change judging and coping program shown in a flow chart of Fig. 7. The program is executed every time after the inspection on a certain substrate which may be influenced by the work-condition change registered in the work-condition-change monitor list is conducted by the inspecting machine that inspects the result of the circuit-substrate-related work in which the work-condition change occurred, more specifically, every time the inspection for each substrate determined as a target of the processing is completed. Each substrate determined as the target of the processing is judged based on the substrate ID stored in the condition-change related data, and the substrate having the substrate ID and some substrates subsequent thereto on which the circuit-substrate-related work was successively performed are determined as the targets as the processing.

With reference to the flow chart, the quality-change judging and coping processing will be explained. In the processing, initially at S21, a value of a quality-deterioration recognition flag Fq is judged. The flag Fq is registered in the list as one of the condition-change related data with its initial value set to "0". When it is recognized that the work quality of the monitor-target portion is deteriorated due to the work-condition change as the processing target, the flag Fq is set to "1". When the quality-deterioration recognition flag Fq is "1", the quality deterioration already occurs. Accordingly, in this instance, the quality improvement processing at S22 (that will be explained) is executed. The judgment as to whether the quality deterioration occurred or not is made on the condition that the circuit-substrate-related work was performed on a predetermined number of substrates from a time point of occurrence of the work-condition change. Accordingly, there is stored, as one of the condition-change related data, a counter Cn for counting a number of the substrates on which the circuit-substrate-related work was performed after the work-condition change. The counter Cn is counted up at S23 when it is judged at S21 that the quality deterioration is not recognized. Subsequently, at S24, if the number of the substrates does not yet reach a preset number Cn₀ (that is preset to a number effective for evaluation of stability later explained), a series of processing according to the program ends. On the other hand, if the number of the substrate has reached the preset number Cn₀, S25 and subsequent steps are executed.

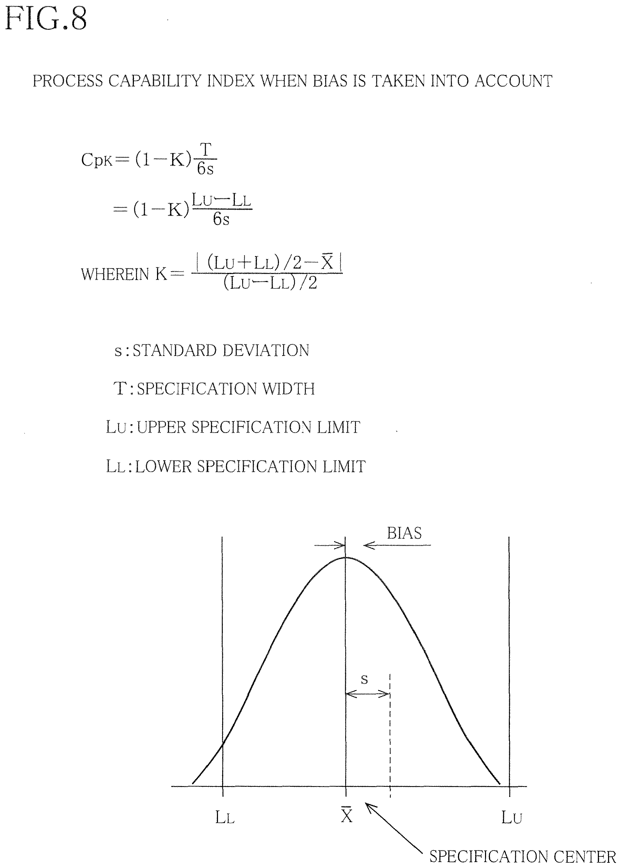

At S25, the comparison data (stored in the information and data storage portion) of the monitor-target portion before occurrence of the work-condition change is extracted. More specifically, there is extracted the comparison data of the substrates that precede, by the set number Cn₀, the substrate for which the work-condition change occurred. Subsequently, at S26, there is calculated an index value Ps_{B} of a stability index of the work result of each monitor-target portion before occurrence of the work-condition change, by utilizing the extracted comparison data. (Hereinafter, the index value of the stability index will be referred to as "stability index value" where appropriate.) More specifically, the stability index value Ps_{B} is calculated for at least one comparison item in the circuit-substrate-related work and its work result. The calculated stability index value Ps_{B} is stored, at S27, in the information and data storage portion as one of the condition-change related data. There may be employable, as the stability index, an index that indicates stability with respect to a deviation from a normal value of the comparison item. More specifically, a process capability index C_{pK} may be employed. The process capability index C_{pK} is a stability index commonly used in the field of quality control and is defined by a formula shown in Fig. 8, for instance. (An upper specification limit Lu and a lower specification limit L_{L} are set so as to be considerably smaller than the above-indicated limit value for failure judgment that is set for the inspecting machine for failure judgment.) In this respect, a larger value of the process capability index C_{pK} indicates a higher degree of stability. As the stability index, in addition to the process capability index C_{pK}, there may be employable various ones such as an average of deviation amounts from a reference value for various deviations as the comparison items, a relationship between the deviation amounts and a control limit value, a distribution range of the deviations, and a number of times or a probability of work errors (conversely, a number of times or a probability of work success).

Subsequently, at S28, the comparison data (stored in the information and data storage portion) of the monitor-target portion after occurrence of the work-condition change is extracted. More specifically, there is extracted the comparison data of the substrates that follow, by the set number Cn₀, the substrate for which the work-condition change occurred. Subsequently, at S29, there is calculated a stability index value Ps_{A} of a stability index of the work result of each monitor-target portion after occurrence of the work-condition change, by utilizing the extracted comparison data. Then, at S30, for each monitor-target portion, the stability index value Ps_{B} before occurrence of the work-condition change and the stability index value Ps_{A} after occurrence of the work-condition change are compared with each other. Where the stability index value Ps is lowered beyond a set threshold ΔPs, it is judged that a degree of the work quality deterioration of the monitor-target portion exceeds a prescribed degree. If it is judged that the work quality is deteriorated beyond the prescribed degree, the quality-deterioration recognition flag Fq is set to "1" at S31, and the improvement action is determined at S32 by referring to an action table. This action table is data in the form of a list in which the work-condition change and the improvement action for dealing with the quality deterioration due to the work-condition change are related to each other. The table is set in advance and is stored in the information and data storage portion. The determined improvement action is notified, at S33, to the circuit-substrate-related-work performing machine in which the work-condition change occurred and the line controller, together with information to the effect that the quality deterioration occurred. Thus, the determined improvement action and the information are notified to the operator via the operation panels of the circuit-substrate-related-work performing machine and the line controller. Where the improvement action can be automatically implemented by the circuit-substrate-related-work performing machine, the circuit-substrate-related-work performing machine that received the notification automatically implements the action. On the other hand, if it is judged at S30 that the work quality of the monitor-target portion is not lowered beyond the prescribed degree, it is judged that there was no deterioration in the work quality due to the work-condition change and this fact is notified, at S34, to the circuit-substrate-related-work performing machine and the line controller. Thereafter, at S35, the work-condition change and the condition-change related data related thereto that are registered in the work-condition-change monitor list are erased therefrom and accordingly excluded from the target of the processing. As a result of completion of S33 or S35, a series of processing according to the program ends.

### [D] Quality Improvement Processing

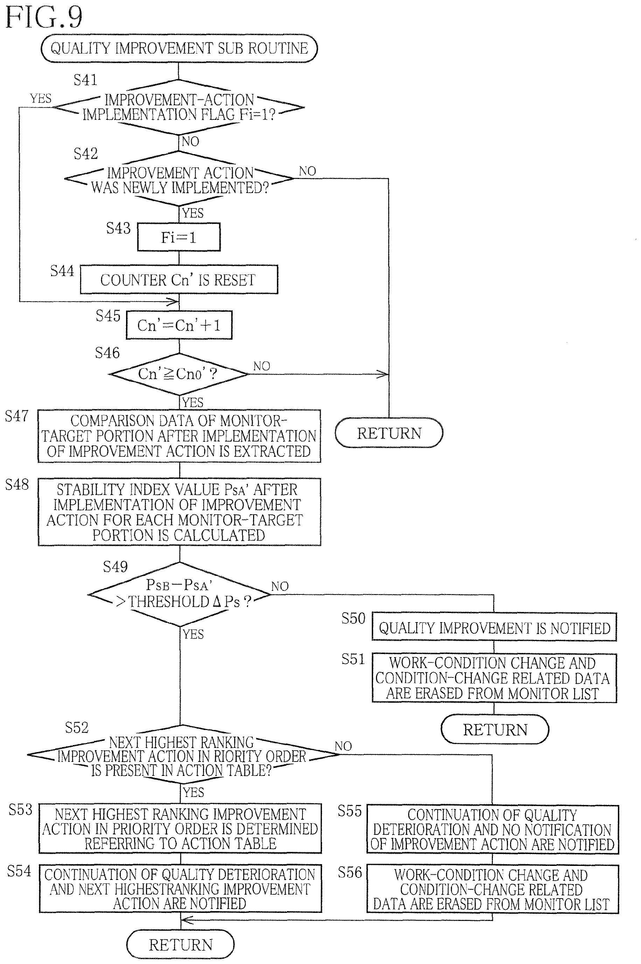

The quality improvement processing is executed at S22 in the quality-change judging and coping processing described above on the condition that the quality deterioration was recognized and the improvement action was once notified. The quality improvement processing is executed by execution of a quality improvement sub routine shown in Fig. 9. In this regard, as a result of completion of this sub routine, the quality-change judging and coping processing ends.

The quality improvement processing will be hereinafter explained with reference to the flow chart. The quality improvement processing is executed on the condition that the improvement action was performed. Accordingly, initially at S41, a judgment based on an improvement-action implementation flag Fi is made. The flag Fi is stored in the information and data storage portion as one of the condition-change related data. The flag Fi is set to "0" when the improvement action was not implemented and is set to "1" when the improvement action was implemented.

The solder printer 24, the component mounter 30, and the reflow furnace 36, each as the circuit-substrate-related-work performing machine, have respective operation panels (Fig. 1). Where the improvement action was implemented by the operator, information that that the action was completed is inputted by the operator to the operation panel of the circuit-substrate-related-work performing machine on which the improvement action was implemented. The information that the action was completed, namely, the action-completion information, is sent from the circuit-substrate-related-work performing machine to the assisting device 10. On the other hand, where the circuit-substrate-related-work performing machine automatically implements the improvement action, the action-completion information is automatically sent from the circuit-substrate-related-work performing machine to the assisting device 10. The assisting device 10 that receives the action-completion information judges whether or not a current substrate that is currently subjected to the quality improvement processing is a substrate on which the circuit-substrate-related work was performed after implementation of the improvement action, on the basis of the received information and the substrate ID of the substrate on which the circuit-substrate-related work was performed after implementation of the improvement action.

Further, there is employed a counter Cn' for counting a number of the substrates on which the circuit-substrate-related work was performed after implementation of the improvement action. The counter Cn' is stored in the condition-change related data as one of the information and data storage portion.

Initially, at S41, a judgment based on the improvement-action implementation flag Fi is made. If any improvement action was not yet implemented, it is judged at S42 whether or not the current substrate is a substrate on which the improvement action was newly implemented. If the improvement action was not newly implemented, a series of processing according to the sub routine ends. If the improvement action was newly implemented, the improvement-action implementation flag Fi is set to "1" at S43. The counter Cn' is reset at S44 and is counted up at S45. On the other hand, if it is judged at S41 that the improvement action was already implemented, S42-S44 are skipped and the counter Cn' is counted up at S45.

After the judgment as to the counter Cn', if it is judged at S46 that the value of the counter Cn' does not reach a set number Cn₀' (that is equal to Cno), a series of processing according to the sub routine ends. If it is judged that the value of the counter Cn' reached the set number Cn₀', there is extracted, at S47, the comparison data (that is stored in the information and data storage portion) of the monitor-target portion after implementation of the improvement action, according to a manner similar to that explained above. More specifically, there is extracted the comparison data of the substrates that follow, by the set number Cn₀', the substrate on which the circuit-substrate-related work was performed after implementation of the improvement action. Subsequently, at S48, there is calculated a stability index value Ps_{A}' of a stability index of the work result of each monitor-target portion after implementation of the improvement action, by utilizing the extracted comparison data, according to a manner similar to that explained above. Subsequently, at S49, for each monitor-target portion, the stability index value Ps_{B} before occurrence of the work-condition change and the stability index value Ps_{A}' after implementation of the improvement action are compared with each other. If the stability index value Ps is lowered beyond the set threshold ΔPs, it is judged that a degree of the work quality deterioration of the monitor-target portion exceeds a prescribed degree, in other words, there are no signs of improvement in the work quality by the improvement action.

If it is judged at S49 that improvement in the work quality can be seen, a notification to the effect that the quality was improved is sent at S50 to the circuit-substrate-related-work performing machine and the line controller 46. Subsequently, at S51, the work-condition change and the condition-change related data related thereto that are registered in the work-condition-change monitor list are erased therefrom and accordingly excluded from the target of the processing. Thereafter, a series of processing according to the sub routine ends. On the other hand, if it is judged at S49 that there are no signs of improvement in the work quality by the improvement action, there is made, at S52, a judgment as to whether the next improvement action is set in the action table. In the action table, a plurality of improvement actions that are arranged in a priority order can be listed. In an instance where a plurality of improvement actions are listed, the improvement action is determined according to the priority order. If the next highest ranking improvement action in the priority order is present, the next highest ranking improvement action in the priority order is determined at S53 referring to the table. That is, in an instance where a plurality of improvement actions are set in the action table, another improvement action is repeatedly determined until the quality improvement can be seen, within a range in which the improvement actions are set. Next, at S54, a notification to the effect that the quality deterioration is continuing and the next highest ranking improvement action are notified to the circuit-substrate-related-work performing machine in which the work-condition change occurred and the line controller 46. If it is judged at S52 that the next improvement action is not set, a notification to the effect that the quality deterioration is still continuing and that the improvement action could not be notified is notified at S55 to the circuit-substrate-related-work performing machine and the line controller 46. Then, at S56, the work-condition change and the condition-change related data related thereto that are registered in the work-condition-change monitor list is erased therefrom and accordingly excluded from the target of the processing. Thereafter, a series of processing according to the sub routine ends.

### [E]Functional Structure of Electric-Circuit-Production Assisting Device

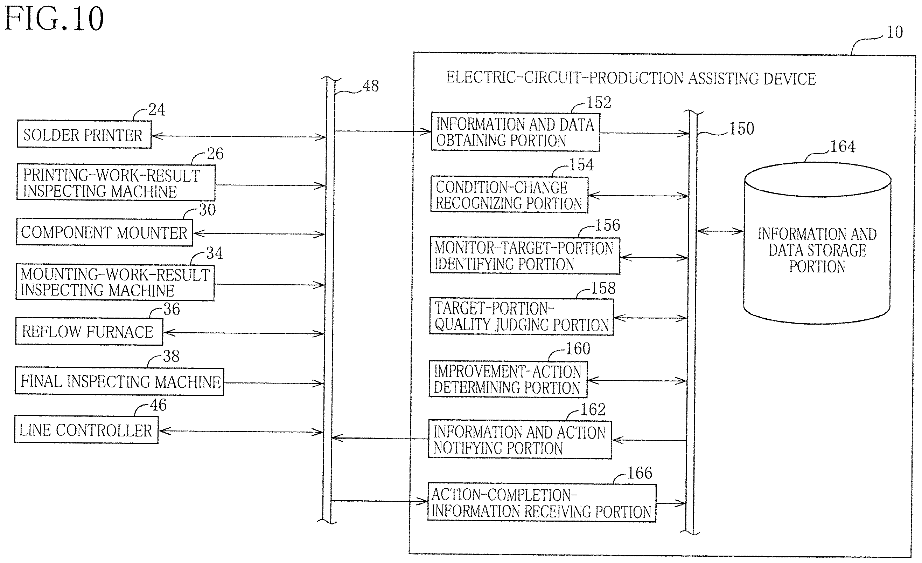

The electric-circuit-production assisting device 10 executes the condition-change recognizing and monitor-target-portion identifying processing, the quality-change judging and coping processing, and the quality improvement processing explained above. Accordingly, the assisting device 10 is regarded to have a functional structure shown in Fig. 10. To be more specific, the assisting device 10 includes the following virtual functional portions that are connected to one another by an internal bus 150: an information and data obtaining portion 152; a condition-change recognizing portion 154; a monitor-target-portion identifying portion 156; a target-portion-quality judging portion 158; an improvement-action determining portion 160; an information and action notifying portion 162; an information and data storage portion 164; and an action-completion-information receiving portion 166. The assisting device 10 is connected to the solder printer 24, the component mounter 30 and the reflow furnace 36 each as the circuit-substrate-related-work performing machine and is connected to the printing-work-result inspecting machine 26, the mounting-work-result inspecting machine 34, and the final inspecting machine 38, via the LAN 48.

The functional portions will be explained below. The information and data obtaining portion 152 has a function of obtaining: the machine-related information such as the work performance information and the action information; and the comparison data such as the operation-based data and the inspection data, from the circuit-substrate-related-work performing machines and the inspecting machines. The condition-change recognizing portion 154 has a function of recognizing the work-condition change on the basis of the machine-related information. The monitor-target-portion identifying portion 156 has a function of specifying the susceptible portions and identifying the monitor-target portion from among the susceptible portions. The target-portion-quality judging portion 158 (as one example of a quality judging portion) has a function of making a judgment as to the change in the work quality in the monitor-target portion on the basis of the comparison data before and after the work-condition change. The improvement-action determining portion 160 has a function of determining the improvement action for coping with a deterioration in the work quality in the monitor-target portion due to the work-condition change. The information and action notifying portion 162 (as one example of an action notifying portion) has a function of notifying the determined improvement action to the circuit-substrate-related-work performing machine and the operator. The information and data storage portion 164 has a function of storing the machine-related information, the comparison data, various sorts of information, various sorts of data, tables, lists, rules, and so on, explained above. The action-completion-information receiving portion 166 has a function of receiving the action-completion information from the circuit-substrate-related-work performing machine or from the operator via the circuit-substrate-related-work performing machine. It is noted that, in the assisting device 10, the target-portion-quality judging portion 158 is configured to make the judgment as to the change in the work quality before and after completion of the improvement action, conditionally on reception of the action-completion information, in other words, by being triggered by reception of the action-completion information.

The functional portions will be explained in detail in connection with the condition-change recognizing and monitor-target-portion identifying processing, the quality-change judging and coping processing, and the quality improvement processing. The condition-change recognizing portion 154 has a function realized by the processing of S1-S9. The monitor-target-portion identifying portion 156 has a function realized by the processing of S10-S12. The target-portion-quality judging portion 158 has a function realized by the processing of S23-S30. The improvement-action determining portion 160 has a function realized by the processing of S32, S52, S53. The information and data storage portion 164 has a function realized by the processing of S33, S34, S50, S54, S55, and so on. The assisting processing executed by the assisting device 10 corresponds to the method of assisting production of the electric circuits (as one example of the method of assisting a circuit-substrate-related-work performing machine). The processing for realizing respective functions of the condition-change recognizing portion 154, the monitor-target-portion identifying portion 156, the target-portion-quality judging portion 158, the improvement-action determining portion 160, and the information and action notifying portion 162 correspond to the condition-change recognizing step, the monitor-target-portion identifying step, the target-portion-quality judging step (as one example of the quality judging step), the improvement-action determining step, and the action notifying step, in the electric-circuit-production assisting method. Further, the processing for receiving the action-completion information executed by the action-completion-information receiving portion 166 corresponds to the action-completion-information receiving step.

### 3. Concrete Examples of Assisting Processing by Electric-Circuit-Production Assisting Device

There will be next explained concrete examples of processing for dealing with some work-condition changes, each as a concrete example of the assisting processing executed by the assisting device 10.

### i) Replacement of Suction Nozzle in Component Mounter

Replacement of the suction nozzle 118, 124 in the component mounter 30 is replacement of the component holding device and is one example of the work-condition change that influences the work quality of the component mounting work, more specifically, the mounting accuracy of the components to be mounted. The replacement of the suction nozzle 118, 124 is recognized by a difference in the work performance information that is the machine-related information, more specifically, a difference in the nozzle ID, between the previously performed substrate and the currently performed substrate. In an instance where the replacement of the suction nozzle 118, 124 is recognized, the components mounted by the suction nozzle 118, 124 used after the replacement are specified as the susceptible portions. As the monitor-target portions, there are identified a largest one of the components, a smallest one of the components, and a component having the largest number of terminals, among the components mounted by the suction nozzle 118, 124. Among the inspection data from the mounting-work-result inspecting machine 34, there are used as the comparison data: the positional deviation amounts of the mount positions for the respective monitor-target portions in each substrate on which the component mounting work was performed before the replacement of the suction nozzle 118, 124; and the positional deviation amounts of the mount positions for the respective monitor-target portions in each substrate on which the component mounting work was performed after the replacement of the suction nozzle 118, 124. For each of the monitor-target portions there are calculated, each as the stability index value, the process capability indices C_{pK} with respect to the positional deviation amount respectively before and after the replacement of the suction nozzle 118, 124. The process capability indices C_{pK} before and after the replacement are compared with each other, whereby the presence or absence of the quality deterioration in each monitor-target portion is judged. Further, among the operation-based data from the component mounter 30, there is used, as the comparison data, the deviation of each of the components as the monitor-target portions, from the axis of the suction nozzle 118, 124, namely, the deviation amount in the suction-holding position of the component by the suction nozzle 118, 124. The deviation, namely, the deviation amount, is obtained on the basis of the image data of the component by the component camera 108. For each of the monitor-target portions, there are calculated, each as the stability index value, the process capability indices C_{pK} with respect to the positional deviation amount respectively before and after the replacement of the suction nozzle 118, 124. The process capability indices C_{pK} before and after the replacement are compared with each other, whereby the presence or absence of the quality deterioration in each monitor-target portion is judged. Among the operation-based data, there is used, as the comparison data, the number of suction-holding errors when each of the components as the monitor-target portions is taken from the component feeder 106 by the suction nozzle 118, 124. For each monitor-target portion, there are calculated, each as the stability index value, suction-holding-error rates (suction-holding-success rates in a strict sense) respectively before and after the replacement of the suction nozzle 118, 124. The suction-holding-error rates are compared with each other, whereby the presence or absence of the quality deterioration in each monitor-target portion is judged. Where it is judged that the quality deterioration is occurring in any of the monitor-target portions, automatic cleaning of the suction nozzle 118, 124 using the nozzle cleaner 128 is determined as the highest ranking improvement action, deflection correction of the nozzle by the operator is determined as the second highest ranking improvement action, and re-replacement of the suction nozzle 118, 124 is determined as the third highest ranking improvement action.

### ii) Change of Component Lot in Component Mounter

When the components are additionally supplied in the component mounter 30 by splicing or replacement of the component feeders 106, there occurs a change in a lot of the components (i.e., component lot change). The component lot change is a work-condition change that influences the work quality of the component mounting work, more specifically, the mounting accuracy of the components. When the component lot change occurs, the component ID is employed as the work performance information that is the machine-related information, and the component lot change is recognized by a difference between the component ID in the previously performed substrate and the component ID in the currently performed substrate. When the component lot change is recognized, the components of the changed lot are specified as the susceptible portions, and all of the components specified as the susceptible portions are identified as the monitor-target portions. Among the inspection data from the mounting-work-result inspecting machine 34, there are used as the comparison data: the positional deviation amounts of the mount portions for the respective monitor-target portions in each substrate on which the component mounting work was performed before the component lot change; and the deviation amounts of the mount positions for the respective monitor-target portions in each substrate on which the component mounting work was performed after the component lot change. For each of the monitor-target portions, there are calculated, each as the stability index value, the process capability indices C_{pK} with respect to the positional deviation amount respectively before and after the component lot change. The process capability indices C_{pK} before and after the component lot change are compared with each other, whereby the presence or absence of the quality deterioration for each monitor-target portion is judged. Further, among the operation-based data from the component mounter 30, there is used, as the comparison data, the deviation of each of the components as the monitor-target portions, from the axis of the suction nozzle 118, 124, namely, the deviation amount in the suction-holding position of the component by the suction nozzle 118, 124. The deviation, namely, the deviation amount, is obtained on the basis of the image data of the component by the component camera 108. For each of the monitor-target portion, there are calculated, each as the stability index value, the process capability indices C_{pK} with respect to the positional deviation amount respectively before and after the component lot change. The process capability indices C_{pK} before and after the component lot change are compared with each other, whereby the presence or absence of the quality deterioration for each monitor-target portion is judged. Further, among the operation-based data, there is used, as the comparison data, the number of suction-holing errors when each of the components as the monitor-target portions is taken from the component feeder 106 by the suction nozzle 118, 124. For each monitor-target portion, there are calculated, each as the stability index value, suction-holding-error rates (suction-holding-success rates in a strict sense) before and after the component lot change. The suction-holding-error rates before and after the component lot change are compared with each other, whereby the presence or absence of the quality deterioration for each monitor-target portion is judged. Where it is judged that the quality deterioration is occurring in any of the monitor-target portions, the improvement action is determined and notified in the following manner. That is, when the component lot was changed by replacing the whole component feeder 106 inclusive the components, there is initially notified, as the improvement action, an action to further replace only the component feeder 106 with another component feeder 106. If no improvement can be seen by the action, there is next notified, as the improvement action, an action to replace the components with components of another lot. On the other hand, when the component lot was changed by replacing only the components by splicing or the like, there is notified, as a single improvement action, an action to further replace the components with components of another lot.

### iii) Cleaning of Screen in Solder Printer

Cleaning of the screen 56 in the solder printer 24 is effective means for preventing a thin spot, an expansion, a protrusion, and so on of the solder land. In the solder printer 24, dry cleaning is periodically and automatically executed. The periodic dry cleaning is a work-condition change in the solder printing work. When the periodic dry cleaning was executed, the fact that the cleaning was executed is sent from the solder printer 24 to the assisting device 10 as the action information that is the machine-related information. The assisting device 10 recognizes the execution of the cleaning as the work-condition change. Where the dry cleaning was executed, all of the solder lands to be printed are specified as the susceptible portions. As the monitor-target portions, there are recognized in each substrate a solder land having the smallest area, a solder land having the largest area, the most adjacent two solder lands, solder lands that are the closest to respective opposite ends of the substrate in the X direction, solder lands that are the closest to respective opposite ends of the substrate in the Y direction, and a solder land located at the center of the substrate. For each monitor-target portion, there are calculated, each as the stability index value, the process capability indices C_{pK} with respect to each of the area change amount and the volume change amount respectively before and after the dry cleaning. The process capability indices C_{pK} before and after the dry cleaning for each monitor-target portion are compared with each other, for judgment of the work quality deterioration. Where the quality deterioration was generated, wet cleaning is determined as the highest ranking improvement action and vacuum cleaning is determined as the second highest ranking improvement action.

### iv) Other Work-Condition Changes

Various other work-condition changes exist other than the above-indicated three examples. Some examples will be described. Examples of the work-condition change for the solder printer 24 are a change of the lot of the substrate, replacement of the squeegee, additional supply of the solder cream, a change in the movement speed of the squeegee, a change in the in-machine temperature. Examples of the work-condition change for the component mounter 30 includes replacement of the mounting head 110, 122, replacement of the mounting module 42, a change of the lot of the substrate, and a change of the mount program as to the mount position. Examples of the work-condition change for the reflow furnace 36 include a change in the temperature profile in the furnace and a change in the substrate conveyance speed. In the assisting device 10, various work-condition changes can be recognized by appropriately selecting the work-machine-related information. As the comparison data, there may be selectable suitable one in accordance with the work-condition change. Further, the specification of the susceptible portions, the rule for identifying the monitor-target portions, the stability index value, the improvement action, etc., can be arbitrarily set. That is, the assisting device 10 is capable of easily dealing with a wide range of kinds of the work-condition changes.

### Modified Example

In the assisting device 10 according to the illustrated embodiment, the monitor-target portions are identified on the basis of the work-condition change, and the quality deterioration in the identified monitor-target portions are judged. The assisting device may be configured to judge the quality deterioration of the circuit-substrate-related work irrespective of the work-condition change and to determine and notify the improvement action.

One example will be explained with regard to the component mounting work by the component mounter 30. For instance, the assisting device may be configured as follows. For all of or a part of the mounted components, there may be always calculated, as each of the stability index value, the process capability indices C_{pK} with respect to the positional deviation amount of each component. Where the quality deterioration in the mounting work of any of the components occurred, an appropriate improvement action may be determined and notified in accordance with the mode of the quality deterioration. To be more specific, where it is judged that the stability is lowered in the components mounted by a specific suction nozzle 118, 124, the improvement action may be determined for that specific suction nozzle 118, 124 and the determined improvement action may be notified, as described above. Further, where it is judged that the stability is lowered in the components supplied from a specific component feeder 106, the improvement action may be determined for that specific component feeder 106 or the components thereof and the determined improvement action may be notified, as described above.

### Description of Reference Signs

10: electric-circuit-production assisting device (circuit-substrate-related-work assisting device) 20: electric-circuit production line 24: solder printer 26: printing-work-result inspecting machine 30: component mounter 34: mounting-work-result inspecting machine 36: reflow furnace 38: final inspecting machine 42: mounting module 46: line controller 56: screen 60: squeegee device 62: cleaning device 106: component feeder (component supply device) 110: mounting head 118: suction nozzle (component holding device) 122: mounting head 124: suction nozzle (component holding device) 126: nozzle stocker 128: nozzle cleaner 152: information and data obtaining portion 154: condition-change recognizing portion 156: monitor-target-portion identifying portion 158: target-portion-quality judging portion 160: improvement-action determining portion 162: information and action notifying portion 164: information and data storage portion 166: action-completion-information receiving portion

## Claims

1. A circuit-substrate-related-work assisting device (10) configured to assist a circuit-substrate-related work performed by a circuit-substrate-related-work performing machine (24, 30, 38) on a circuit substrate that constitutes an electric circuit, comprising:
a quality judging portion (158) configured to make a judgment as to a change in work quality of the circuit-substrate-related-work performing machine (24, 30, 38);
an improvement-action determining portion (160) configured to determine an improvement action for improving the work quality where the quality judging portion (158) judges that a degree of deterioration of the work quality exceeds a prescribed degree;
an action notifying portion (162) configured to notify at least one of the circuit-substrate-related-work performing machine (24, 30, 38) and an operator of the circuit-substrate-related-work performing machine (24, 30, 38) of the improvement action determined by the improvement-action determining portion (160); and
an action-completion-information receiving portion (166) configured to receive, from at least one of the circuit-substrate-related-work performing machine (24, 30, 38) and the operator, action-completion information that is information as to completion of the improvement action notified by the action notifying portion (162),
wherein
the quality judging portion (158) is configured to judge whether the circuit substrate is the circuit substrate on which the circuit substrate related work was performed after implementation of the improvement action and to make a judgment as to a change in the work quality before and after the completion of the improvement action, conditionally on reception of the action-completion information by the action-completion-information receiving portion (166),
the improvement-action determining portion (160) is configured to determine another improvement action different from the determined improvement action where there are no signs of improvement in the work quality even though the determined improvement action has been implemented on the circuit-substrate-related-work performing machine (24, 30, 38), and
the improvement-action determining portion (160) is configured to determine said another improvement action according to a priority order set in advance.

2. The circuit-substrate-related-work assisting device (10) according to claim 1, wherein the quality judging portion (158) is configured to make the judgment as to the change in the work quality, based on stability for at least one of the circuit-substrate-related work and a work result of the circuit-substrate-related work.

3. The circuit-substrate-related-work assisting device (10) according to claim 1 or 2, wherein the circuit-substrate-related-work performing machine (24, 30, 38) is a component mounter (30) configured to perform, as the circuit-substrate-related work, a component mounting work for mounting electric components on the circuit substrate, and the circuit-substrate-related-work assisting device (10) is a device for assisting the component mounting work.

4. The circuit-substrate-related-work assisting device (10) according to claim 1 or 2, wherein the circuit-substrate-related-work performing machine (24, 30, 38) is a solder printer (24) configured to perform, as the circuit-substrate-related work, a solder printing work for printing solder cream on the circuit substrate, and the circuit-substrate-related-work assisting device (10) is a device for assisting the solder printing work.

5. A method of assisting a circuit-substrate-related work to be performed by a circuit-substrate-related-work performing machine (24, 30, 38) on a circuit substrate that constitutes an electric circuit, the method comprising:
a quality judging step of making a judgment as to a change in work quality of the circuit-substrate-related-work performing machine (24, 30, 38);
an improvement-action determining step of determining an improvement action for improving the work quality where it is judged in the quality-judging step that a degree of deterioration of the work quality exceeds a prescribed degree;
an action notifying step of notifying at least one of the circuit-substrate-related-work performing machine (24, 30, 38) and an operator of the circuit-substrate-related-work performing machine (24, 30, 38) of the improvement action determined in the improvement-action determining step; and
an action-completion-information receiving step of receiving, from at least one of the circuit-substrate-related-work performing machine (24, 30, 38) and the operator, action-completion information that is information as to completion of the improvement action notified in the action notifying step,
wherein
in the quality judging step, it is judged whether the circuit substrate is the circuit substrate on which the circuit substrate related work was performed after implementation of the improvement action, and a judgment as to a change in the work quality before and after the completion of the improvement action is made conditionally on reception of the action-completion information in the action-completion-information receiving step,
another improvement action different from the determined improvement action is determined where there are no signs of improvement in the work quality even though the determined improvement action has been implemented on the circuit-substrate-related-work performing machine (24, 30, 38), and
the another improvement action is determined according to a priority order set in advance.

## Patentansprüche

1. Vorrichtung (10) zur Unterstützung von schaltungssubstratbezogener Arbeit, die konfiguriert ist, um eine schaltungssubstratbezogene Arbeit zu unterstützen, die von einer Maschine (24, 30, 38) zum Durchführen der schaltungssubstratbezogenen Arbeit an einem Schaltungssubstrat durchgeführt wird, das eine elektrische Schaltung bildet, umfassend:
einen Qualitätsbeurteilungsteil (158), der konfiguriert ist, um eine Beurteilung hinsichtlich einer Änderung der Arbeitsqualität der Maschine (24, 30, 38) zum Durchführen von schaltungssubstratbezogener Arbeit vorzunehmen;
einen Verbesserungsmaßnahmenbestimmungsteil (160), der konfiguriert ist, um eine Verbesserungsmaßnahme zum Verbessern der Arbeitsqualität zu bestimmen, wobei der Qualitätsbeurteilungsteil (158) beurteilt, dass ein Grad der Verschlechterung der Arbeitsqualität einen vorgeschriebenen Grad überschreitet;
einen Maßnahmenmeldeteil (162), der konfiguriert ist, um wenigstens der Maschine (24, 30, 38) zum Durchführen von schaltungssubstratbezogener Arbeit oder einem Bediener der Maschine (24, 30, 38) zum Durchführen von schaltungssubstratbezogener Arbeit die durch den Verbesserungsmaßnahmenbestimmungsteil (160) bestimmte Verbesserungsmaßnahme zu melden; und
einen Empfangsteil (166) für Maßnahmenbeendigungsinformationen, der konfiguriert ist, um wenigstens von der Maschine (24, 30, 38) zum Durchführen von schaltungssubstratbezogener Arbeit oder vom Bediener Maßnahmenbeendigungsinformationen zu empfangen, die Informationen hinsichtlich der Beendigung der vom Maßnahmenmeldeteil (162) gemeldeten Verbesserungsmaßnahme ist,
wobei
der Qualitätsbeurteilungsteil (158) konfiguriert ist, um zu beurteilen, ob das Schaltungssubstrat das Schaltungssubstrat ist, auf dem die schaltungssubstratbezogene Arbeit nach der Umsetzung der Verbesserungsmaßnahme durchgeführt wurde, und eine Beurteilung hinsichtlich einer Änderung der Arbeitsqualität vor und nach der Beendigung der Verbesserungsmaßnahme vorbehaltlich des Empfangens der Maßnahmenbeendigungsinformationen durch den Empfangsteil (166) für Maßnahmenbeendigungsinformationen vorzunehmen,
der Verbesserungsmaßnahmenbestimmungsteil (160) konfiguriert ist, um eine andere Verbesserungsmaßnahme zu bestimmen, die sich von der bestimmten Verbesserungsmaßnahme unterscheidet, wenn es keine Anzeichen für eine Verbesserung der Arbeitsqualität gibt, obwohl die bestimmte Verbesserungsmaßnahme an der Maschine (24, 30, 38) zum Durchführen von schaltungssubstratbezogener Arbeit umgesetzt wurde, und
der Verbesserungsmaßnahmenbestimmungsteil (160) konfiguriert ist, um die andere Verbesserungsmaßnahme entsprechend einer im Voraus festgelegten Prioritätsreihenfolge zu bestimmen.

2. Vorrichtung (10) zur Unterstützung von schaltungssubstratbezogener Arbeit nach Anspruch 1, wobei der Qualitätsbeurteilungsteil (158) konfiguriert ist, um die Beurteilung hinsichtlich der Änderung der Arbeitsqualität auf der Basis der Stabilität für wenigstens die schaltungssubstratbezogene Arbeit oder ein Arbeitsergebnis der schaltungssubstratbezogenen Arbeit vorzunehmen.

3. Vorrichtung (10) zur Unterstützung von schaltungssubstratbezogener Arbeit nach Anspruch 1 oder 2, wobei die Maschine (24, 30, 38) zum Durchführen von schaltungssubstratbezogener Arbeit eine Komponentenmontagevorrichtung (30) ist, die konfiguriert ist, um als die schaltungssubstratbezogene Arbeit eine Komponentenmontagearbeit zum Montieren elektrischer Komponenten auf dem Schaltungssubstrat durchzuführen, und die Vorrichtung (10) zur Unterstützung von schaltungssubstratbezogener Arbeit eine Vorrichtung zur Unterstützung der Komponentenmontagearbeit ist.

4. Vorrichtung (10) zur Unterstützung von schaltungssubstratbezogener Arbeit nach Anspruch 1 oder 2, wobei die Maschine (24, 30, 38) zum Durchführen von schaltungssubstratbezogener Arbeit ein Lötdrucker (24) ist, der konfiguriert ist, um als die schaltungssubstratbezogene Arbeit eine Lötdruckarbeit zum Drucken von Lötcreme auf das Schaltungssubstrat durchzuführen, und die Vorrichtung (10) zur Unterstützung von schaltungssubstratbezogener Arbeit eine Vorrichtung zur Unterstützung der Lötdruckarbeit ist.

5. Verfahren zur Unterstützung von schaltungssubstratbezogener Arbeit, das von einer Maschine (24, 30, 38) zum Durchführen von schaltungssubstratbezogener Arbeit an einem Schaltungssubstrat durchzuführen ist, das eine elektrische Schaltung bildet, wobei das Verfahren umfasst:
einen Qualitätsbeurteilungsschritt zum Vornehmen einer Beurteilung hinsichtlich einer Änderung der Arbeitsqualität der Maschine (24, 30, 38) zum Durchführen von schaltungssubstratbezogener Arbeit;
einen Verbesserungsmaßnahmenbestimmungsschritt zum Bestimmen einer Verbesserungsmaßnahme zum Verbessern der Arbeitsqualität, wobei im Qualitätsbeurteilungsschritt beurteilt wird, dass ein Grad der Verschlechterung der Arbeitsqualität einen vorgeschriebenen Grad überschreitet;
einen Maßnahmenmeldeschritt zum Melden wenigstens der Maschine (24, 30, 38) zum Durchführen von schaltungssubstratbezogener Arbeit oder dem Bediener der Maschine (24, 30, 38) zum Durchführen von schaltungssubstratbezogener Arbeit der im Verbesserungsmaßnahmenbestimmungsschritt bestimmten Verbesserungsmaßnahme; und
einen Maßnahmenbeendigungsinformationsempfangsschritt zum Empfangen von wenigstens der Maschine (24, 30, 38) zum Durchführen von schaltungssubstratbezogener Arbeit oder dem Bediener von Maßnahmenbeendigungsinformationen, die Informationen hinsichtlich der Beendigung der vom Maßnahmenmeldeteil gemeldeten Verbesserungsmaßnahme sind,
wobei
im Qualitätsbeurteilungsschritt beurteilt wird, ob das Schaltungssubstrat das Schaltungssubstrat ist, auf dem die schaltungssubstratbezogene Arbeit nach der Umsetzung der Verbesserungsmaßnahme durchgeführt wurde, und eine Beurteilung hinsichtlich einer Änderung der Arbeitsqualität vor und nach der Beendigung der Verbesserungsmaßnahme vorbehaltlich des Empfangens der Maßnahmenbeendigungsinformationen im Maßnahmenbeendigungsinformationsempfangsschritt vorgenommen wird,
eine andere Verbesserungsmaßnahme, die sich von der bestimmten Verbesserungsmaßnahme unterscheidet, bestimmt wird, wenn es keine Anzeichen für eine Verbesserung der Arbeitsqualität gibt, obwohl die bestimmte Verbesserungsmaßnahme an der Maschine (24, 30, 38) zum Durchführen von schaltungssubstratbezogener Arbeit umgesetzt wurde, und
die andere Verbesserungsmaßnahme nach einer im Voraus festgelegten Prioritätsreihenfolge bestimmt wird.

## Revendications

1. Dispositif d'aide à des opérations liées à un substrat de circuit (10) configuré pour assister une opération liée à un substrat de circuit effectuée par une machine d'exécution d'opérations liées à un substrat de circuit (24, 30, 38) sur un substrat de circuit qui constitue un circuit électrique, comprenant :
une partie de jugement de qualité (158) configurée pour porter un jugement quant à un changement dans une qualité d'opération de la machine d'exécution d'opérations liées à un substrat de circuit (24, 30, 38) ;
une partie de détermination d'action d'amélioration (160) configurée pour déterminer une action d'amélioration pour améliorer une qualité d'opération où la partie de jugement de qualité (158) juge qu'un niveau de détérioration de la qualité d'opération dépasse un niveau prescrit ;
une partie de notification d'action (162) configurée pour notifier au moins un de la machine d'exécution d'opérations liées à un substrat de circuit (24, 30, 38) et d'un opérateur de la machine d'exécution d'opérations liées à un substrat de circuit (24, 30, 38) de l'action d'amélioration déterminée par la partie de détermination d'action d'amélioration (160) ; et
une partie de réception d'informations d'achèvement d'action (166) configurée pour recevoir, d'au moins un de la machine d'exécution d'opérations liées à un substrat de circuit (24, 30, 38) et de l'opérateur, d'informations d'achèvement d'action qui sont des informations relatives à l'achèvement de l'action d'amélioration notifiée par la partie de notification d'action (162),
dans lequel
la partie de jugement de qualité (158) est configurée pour juger si le substrat de circuit constitue le substrat de circuit sur lequel l'opération liée à un substrat de circuit a été effectuée après une mise en œuvre de l'action d'amélioration et pour porter un jugement quant à un changement dans la qualité de travail avant et après l'achèvement de l'action d'amélioration, conditionnellement sur réception des informations d'achèvement d'action par la partie de réception d'informations d'achèvement d'action (166),
la partie de détermination d'action d'amélioration (160) est configurée pour déterminer une autre action d'amélioration différente de l'action d'amélioration déterminée où aucun signe d'amélioration dans la qualité d'opération n'est présent même si l'action d'amélioration déterminée a été mise en œuvre sur la machine d'exécution d'opérations liées à un substrat de circuit (24, 30, 38), et
la partie de détermination d'action d'amélioration (160) est configurée pour déterminer ladite autre action d'amélioration selon un ordre de priorité défini à l'avance.

2. Le dispositif d'aide à des opérations liées à un substrat de circuit (10) selon la revendication 1, dans lequel la partie de jugement de qualité (158) est configurée pour porter le jugement quant au changement dans la qualité d'opération, selon une stabilité pour au moins un de l'opération liée à un substrat de circuit et d'un résultat d'opération de l'opération liée à un substrat de circuit.

3. Le dispositif d'aide à des opérations liées à un substrat de circuit (10) selon la revendication 1 ou 2, dans lequel la machine d'exécution d'opérations liées à un substrat de circuit (24, 30, 38) est un monteur de composant (30) configuré pour exécuter, en tant que l'opération liée à un substrat de circuit, une opération de montage de composant pour monter des composants électriques sur le substrat de circuit, et le dispositif d'aide à des opérations liées à un substrat de circuit (10) est un dispositif pour aider à l'opération de montage de composant.

4. Le dispositif d'aide à des opérations liées à un substrat de circuit (10) selon la revendication 1 ou 2, dans lequel la machine d'exécution d'opérations liées à un substrat de circuit (24, 30, 38) est une sérigraphieuse de brasage (24) configurée pour exécuter, en tant que l'opération liée à un substrat de circuit, une opération de sérigraphie de brasage pour sérigraphier une crème de brasage sur le substrat de circuit, et le dispositif d'aide à des opérations liées à un substrat de circuit (10) est un dispositif pour aider à l'opération de sérigraphie de brasage.

5. Procédé d'aide à une opération liée à un substrat de circuit effectuée par une machine d'exécution d'opérations liées à un substrat de circuit (24, 30, 38) sur un substrat de circuit qui constitue un circuit électrique, le procédé comprenant :
une étape de jugement de qualité de jugement quant à un changement dans une qualité d'opération de la machine d'exécution d'opérations liées à un substrat de circuit (24, 30, 38) ;
une étape de détermination d'action d'amélioration de détermination d'une action d'amélioration pour améliorer la qualité d'opération où il est jugé à l'étape de jugement de qualité qu'un niveau de détérioration de la qualité d'opération dépasse un niveau prescrit ;
une étape de notification d'action de notification à au moins un de la machine d'exécution d'opérations liées à un substrat de circuit (24, 30, 38) et d'un opérateur de la machine d'exécution d'opérations liées à un substrat de circuit (24, 30, 38) de l'action d'amélioration déterminée à l'étape de détermination d'action d'amélioration ; et
une partie de réception d'informations d'achèvement d'action (166) configurée pour recevoir, d'au moins un de la machine d'exécution d'opérations liées à un substrat de circuit (24, 30, 38) et de l'opérateur, d'informations d'achèvement d'action qui sont des informations relatives à l'achèvement de l'action d'amélioration notifiée par la partie de notification d'action (162),
dans lequel
la partie de jugement de qualité (158) est configurée pour juger si le substrat de circuit constitue le substrat de circuit sur lequel l'opération liée à un substrat de circuit a été effectuée après une mise en œuvre de l'action d'amélioration et pour porter un jugement quant à un changement dans la qualité de travail avant et après l'achèvement de l'action d'amélioration, conditionnellement sur réception des informations d'achèvement d'action par la partie de réception d'informations d'achèvement d'action (166),
une autre action d'amélioration différente de l'action d'amélioration déterminée est déterminée où aucun signe d'amélioration dans la qualité d'opération n'est présent même si l'action d'amélioration déterminée a été mise en œuvre sur la machine d'exécution d'opérations liées à un substrat de circuit (24, 30, 38), et
l'autre action d'amélioration est déterminée selon un ordre de priorité défini à l'avance.
